# FASCICULE DE BREVET EUROPEEN

(11) **EP 4 454 444 B1**
(45) Date de publication et mention de la délivrance du brevet: **04.02.2026**
(21) Numéro de dépôt: 22839367.4
(22) Date de dépôt: 22.12.2022
(51) Int. Cl.: H10N 70/00, H10N 70/20, G11C 11/16, G11C 13/00

(54) **ENSEMBLE COMPRENANT AU MOINS DEUX MÉMOIRES RÉSISTIVES NON-VOLATILES ET UN SÉLECTEUR, MATRICE ET PROCÉDÉS DE FABRICATION ASSOCIÉS**
ANORDNUNG MIT MINDESTENS ZWEI NICHTFLÜCHTIGEN RESISTIVEN SPEICHERN UND EINEM SELEKTOR, MATRIX UND ZUGEHÖRIGES HERSTELLUNGSVERFAHREN
ASSEMBLY COMPRISING AT LEAST TWO NON-VOLATILE RESISTIVE MEMORIES AND A SELECTOR, MATRIX AND ASSOCIATED MANUFACTURING METHODS

(30) Priorité: 23.12.2021 FR 2114442
(43) Date de publication de la demande: 30.10.2024
(73) Titulaire: Commissariat à l'Energie Atomique et aux Energies Alternatives, 75015 Paris (FR); Weebit Nano Ltd, 4523001 Hod-Hasharon (IL)
(72) Inventeur: DORY, Jean-Baptiste, 38054 GRENOBLE CEDEX 09 (FR); MOLAS, Gabriel, 38054 GRENOBLE CEDEX 09 (FR); NODIN, Jean-François, 38054 GRENOBLE CEDEX 09 (FR); VERDY, Anthonin, 38040 GRENOBLE CEDEX 09 (FR)
(74) Mandataire: Cabinet Camus Lebkiri
(86) Numéro de dépôt international: PCT/EP2022/087634
(87) Numéro de publication internationale: WO 2023/118519

(56) Documents cités:
- CN-A- 112 585 758
- US-A1- 2020 411 754
- US-B1- 10 199 434

## Description

### DOMAINE TECHNIQUE DE L'INVENTION

Le domaine technique de l'invention est celui des mémoires résistives non-volatiles. Il concerne également la fabrication de telles mémoires.

### ARRIÈRE-PLAN TECHNOLOGIQUE DE L'INVENTION

L'invention s'insère dans le développement de matrices de mémoires dites « crossbar » en anglais, dans lesquelles une pluralité de points mémoire sont chacun situés au croisement entre une ligne conductrice et une colonne conductrice. Chaque point mémoire est alors adressé, par exemple par l'application d'une tension entre la ligne conductrice et la colonne conductrice auxquelles il est connecté.

L'invention concerne plus particulièrement des points mémoire comprenant une mémoire résistive, c'est à dire une mémoire dans laquelle l'information est stockée sous la forme d'une valeur de résistance électrique. Une mémoire résistive peut être de différents types, selon les phénomènes mis en œuvre pour écrire, stocker et lire l'information.

Les mémoires résistives sont typiquement réalisées dans des couches situées au-dessus d'un substrat (par exemple un substrat en Silicium) sur lequel est réalisée la matrice. On parle alors de composants appartenant au BEOL pour « Back-End-Of-Line » en anglais (fabriqués lors des étapes finales de fabrication), contrairement aux composants appartenant au FEOL pour « Front-End-Of-Line » (FEOL) en anglais. Les composants appartement au BEOL sont par exemple intégrés entre les niveaux métalliques d'interconnexion. Les composants FEOL sont fabriqués à la surface du substrat (diodes et transistors CMOS par exemple).

Par exemple, une mémoire dite « à changement de phase » ou PCRAM pour « Phase Change Random Access Memory » en anglais met en œuvre le fort contraste de propriétés électroniques entre une phase amorphe et une phase cristalline d'un matériau.

Une mémoire dite « à pont conducteur » ou CBRAM pour « Conductive Bridge RAM » en anglais, met en œuvre la formation/dissolution d'un filament conducteur dans un électrolyte solide suite à une diffusion d'ions provenant d'une électrode active.

Une mémoire dite « à claquage réversible d'oxyde » ou OxRAM pour « Oxide RAM » en anglais, met en œuvre le claquage réversible d'un matériau diélectrique en fonction d'une tension électrique appliquée à ce matériau.

Une mémoire dite magnétique ou MRAM pour « Magnetic RAM » en anglais, met en œuvre l'aimantation relative entre une couche magnétique de référence et une couche magnétique programmable.

L'utilisation des mémoires résistives se révèle une solution prometteuse pour l'augmenter la densité des matrices de mémoires. Elles s'insèrent également dans le développement de nouvelles applications telles que le calcul dit « neuromorphique » ou le développement d'une nouvelle classe de mémoires appelée « Storage Class Memory » en anglais. Cependant, les mémoires résistives peuvent présenter différents inconvénients.

Dans une matrice de points mémoire, une pluralité de mémoires résistives sont connectées à une même ligne ou une même colonne. L'application d'une tension d'adressage aux bornes d'une de ces mémoires (par exemple pour la lire) crée toutefois un courant de fuite non-négligeable au niveau des autres mémoires de la même ligne, et de la même colonne. Ce courant de fuite dégrade les capacités de lecture et/ou d'écriture de l'information au niveau d'une des mémoires.

Afin de résoudre ce problème, il est connu d'ajouter des dispositifs de sélection, appelé « sélecteurs », relié chacun en série avec chaque mémoire (agencement de type « 1S1R »). L'activation d'un seul sélecteur parmi la pluralité des sélecteurs permet ainsi de sélectionner une seule mémoire, tandis que les autres sélecteurs, bloqués, suppriment ou réduisent les courants de fuites des autres mémoires.

Un type de sélecteur cointégrable dans le « back-end », appelé sélecteur « cointégrable » ou sélecteur « back end » dans la suite, offre une facilité de cointégration avec la mémoire, en série avec celle-ci, ses dimensions pouvant être ajustées aux dimensions de la mémoire résistive. En effet, l'état passant d'un sélecteur « back-end » est suffisamment conducteur et permet de réduire ses dimensions au même niveau que celles de la mémoire avec laquelle il peut être connecté en série. Par ailleurs, un sélecteur « back-end » peut être formé de couches déposées sur ou sous un couche mémoire, et gravées en bloc, en même temps que la couche mémoire. Il existe plusieurs types de sélecteurs back-end. Il existe plusieurs types de sélecteurs back-end dont une liste non exhaustive regroupe les types suivants :

Un sélecteur ovonique à seuil ou OTS pour « Ovonic Threshold Switching » en anglais, met en œuvre une propriété caractéristique de certains matériaux chalcogénures ; Il s'agit du passage, sous l'effet d'un champ électrique, d'un état résistif à un état conducteur métastable ; L'état conducteur métastable peut être maintenu aussi longtemps qu'un courant de maintien circule dans le sélecteur OTS ; En dehors de quoi, le sélecteur OTS retrouve l'état résistif (état bloqué) ;

Un sélecteur à pont conducteur instable ou TS pour « Threshold Switch » en anglais, met en œuvre la formation d'un filament métallique métastable par la diffusion, sous l'effet d'un champ électrique, d'une électrode active dans un électrolyte ; Lorsque le champ n'est plus appliqué, le filament métallique métastable se dissout ;

Un sélecteur à conduction électronique et ionique ou MIEC pour « Mixed ion-electronic conduction » en anglais, met en œuvre la mobilité d'ions métalliques permettant la création d'un courant électrique sous l'effet d'un champ électrique ;

Un sélecteur à transition métal-isolant met en œuvre un matériau à forte corrélation électronique nécessitant l'application d'un champ électrique dépassant un champ seuil pour créer un courant électrique, le champ seuil étant fonction de la répulsion coulombienne forçant la localisation des électrons libres dudit matériau ;

Un sélecteur à barrière Schottky ou barrière tunnel mettant en œuvre une forte non-linéarité dans sa caractéristique courant-tension.

Un point mémoire comprenant un sélecteur « back-end » offre un encombrement réduit et sa fabrication est commode (il peut être gravé en même temps que la partie mémoire résistive du point mémoire). Toutefois, la bonne fonctionnalité de l'ensemble repose sur une faible variabilité des propriétés électriques de son sélecteur et de sa mémoire.

Dans ce contexte, il est connu de mettre en œuvre un transistor ou une diode de sélection à la place d'un sélecteur « back-end », (en effet, les transistors ou les diodes de sélection permettent de réaliser la même fonction qu'un sélecteur cointégrable dans le back-end), et de mettre en œuvre un agencement de type « 1TnR » où n est le nombre de mémoires partagées par un même transistor. Comme plusieurs mémoires partagent le même « sélecteur » (plus précisément, le même transistor), le problème de variabilité des caractéristiques individuelles, d'un sélecteur à l'autre, est en partie résolu (en tout cas à l'échelle du groupe de n mémoires en question). Mais l'utilisation d'un transistor comme sélecteur augmente nettement l'encombrement de l'ensemble.

Le document US2020411754 A1 montre une cellule mémoire à changement de phase disposée sur une couche d'électrode et une couche sélectrice. Le document CN112585758 A divulgue une structure de mémoire électronique PCM tridimensionnelle comprenant une couche sélectrice et un revêtement de nitrure dans chaque rangée qui s'étend sur toute la hauteur de la rangée de part et d'autre de chaque cellule et le document US10199434B1 révèle un dispositif de mémoire à changement de phase comprenant une pile verticale de multiples réseaux bidimensionnels de piliers où les multiples réseaux bidimensionnels de structures de piliers comprennent un élément de mémoire à changement de phase et un élément sélecteur en connexion en série avec l'élément de mémoire à changement de phase.

Il existe donc un besoin de fournir un ensemble comprenant au moins une mémoire résistive associée à un sélecteur de type « back-end », qui soit peu encombrant, commode à fabriquer, et dans lequel le problème de variabilité mentionné ci-dessus soit au moins partiellement résolu.

### RÉSUMÉ DE L'INVENTION

L'invention concerne un ensemble comprenant au moins deux mémoires résistives non volatiles disposées électriquement en parallèle entre elles et étant chacune électriquement connectées en série à une couche sélectrice commune, l'ensemble comprenant :
- un empilement sélecteur, comprenant :
   - une couche sélectrice qui s'étend parallèlement à un plan donné ;
   - une électrode supérieure de sélecteur s'étendant sur la couche sélectrice, l'électrode supérieure étant délimitée latéralement par une surface latérale ;
- un premier empilement mémoire, qui s'étend de manière oblique ou perpendiculaire par rapport audit plan, comprenant une première couche active, une partie au moins de la première couche active s'étendant contre une partie de la surface latérale de l'électrode supérieure de sélecteur ;
- un deuxième empilement mémoire, qui s'étend de manière oblique ou perpendiculaire par rapport audit plan, comprenant une deuxième couche active, une partie au moins de la deuxième couche active s'étendant contre une autre partie de la surface latérale de l'électrode supérieure de sélecteur ;
- les premier et deuxième empilements mémoire étant disjoints, sans contact électrique direct entre eux ;
- un premier contact électrique, la première couche active étant connectée électriquement entre, le premier contact électrique d'une part, et, l'électrode supérieure de sélecteur d'autre part ;
- un deuxième contact électrique, la deuxième couche active étant connectée électriquement entre, le deuxième contact électrique d'une part, et, l'électrode supérieure de sélecteur d'autre part ;
- l'électrode supérieure de sélecteur étant commune aux premier et deuxième empilements mémoire tandis que les premier et deuxième contacts sont isolés électriquement l'un de l'autre, sans contact électrique direct entre eux.

Les premier et deuxième empilements mémoires, adressables indépendamment l'un de l'autre, permettent de stocker de manière distincte une information de manière non volatile. Chaque information peut être encodée sous la forme d'une valeur de résistance dans les première et deuxième couches actives.

Comme expliqué en détail en référence aux figures, l'orientation oblique par rapport au plan en question, ou même perpendiculaire à ce plan, d'une partie au moins des première et deuxième couches actives, combinée à l'utilisation d'une même couche sélectrice commune, horizontale, permet d'étendre la couche sélectrice tout en maintenant un encombrement réduit, et conduit ainsi à une variabilité réduite (meilleure reproductibilité/prédictibilité) des caractéristiques électriques de ce dispositif mémoire.

La partie de la première couche active, qui s'étend contre la partie en question de la surface latérale de l'électrode supérieure de sélecteur, peut s'étendre directement contre cette surface latérale (i.e.: sans couche intermédiaire), ou s'étendre contre cette surface latérale par l'intermédiaire d'une couche annexe intercalée entre les deux. Quoiqu'il en soit, cette partie de la première couche active s'étend en vis-à-vis de cette partie de la surface latérale de l'électrode supérieure de sélecteur, par exemple parallèlement à celle-ci.

Il en est de même pour la partie de la deuxième couche active, qui s'étend contre l'autre partie de la surface latérale de l'électrode supérieure de sélecteur.

Outre les caractéristiques qui viennent d'être évoquées dans le paragraphe précédent, l'ensemble selon l'invention peut présenter une ou plusieurs caractéristiques complémentaires parmi les suivantes, considérées individuellement ou selon toutes les combinaisons techniquement possibles :
- la couche sélectrice est délimitée latéralement par une surface latérale située, par exemple, dans le prolongement de la surface latérale de l'électrode supérieure de sélecteur ;
- la couche sélectrice est située entre l'électrode supérieure de sélecteur et un via inférieur conducteur qui est situé sous la couche sélectrice ;
- le via inférieur a une section inférieure à la section de la couche sélectrice et étant entouré par un matériau diélectrique qui s'étend sous la couche sélectrice ;
- le via inférieur est délimité latéralement par une surface latérale ;
- le premier empilement mémoire est délimité par une surface latérale externe, qui est la surface latérale la plus externe de cet empilement, la plus éloignée de la couche sélectrice ;
- une partie de la surface latérale du via inférieur, qui est située du côté du premier empilement mémoire, et la surface latérale externe du premier empilement mémoire sont toutes deux situées sous le premier contact électrique (en projection sur le plan horizontale en question, elles ne débordent pas latéralement, par rapport à ce contact supérieur) ;
- une partie de la surface latérale du via inférieur, qui est située du côté du premier empilement mémoire, et la surface latérale externe du premier empilement mémoire sont toutes deux situées sous le premier contact électrique, en alignement avec celui-ci ;
- la ou les couches actives, qui s'étendent en partie au moins contre ladite partie ou ladite autre partie de la surface latérale de l'électrode supérieure du sélecteur, sont en contact avec cette surface latérale, directement, ou par l'intermédiaire d'une couche électriquement conductrice ;
- l'ensemble comprend en outre un espaceur électriquement isolant, qui s'étend au moins contre la surface latérale de la couche sélectrice, une partie de la première couche active étant séparée de la surface latérale de la couche sélectrice par cet espaceur ;
- l'espaceur s'étend en outre contre la surface latérale de l'électrode supérieure de sélecteur, entre une partie de la première couche active et la surface latérale de l'électrode supérieure de sélecteur ;
- la première couche active comprend une portion qui s'étend parallèlement audit plan en venant recouvrir une partie de l'électrode supérieure de sélecteur, et qui est en contact avec une surface supérieure de l'électrode supérieure de sélecteur ;
- l'ensemble comprend au moins un empilement sélecteur additionnel, situé au-dessus et au droit (à la verticale) de l'empilement sélecteur, séparé de l'empilement sélecteur par une couche isolante ;
- l'empilement sélecteur additionnel comprend :
   - sur ladite couche isolante, une électrode de sélecteur additionnelle, délimitée latéralement par une surface latérale dite additionnelle ; et
   - sur l'électrode de sélecteur additionnelle, une couche sélectrice additionnelle ;
- la première couche active s'étend en outre contre une partie de la surface latérale additionnelle de l'électrode supérieure de sélecteur additionnelle ; la deuxième couche active s'étend contre une autre partie de la surface latérale additionnelle de l'électrode de sélecteur additionnelle ;
- l'ensemble comprend en outre un via supérieur, situé au-dessus de la couche sélectrice additionnelle et relié électriquement à la couche sélectrice additionnelle ;
- le via supérieur a une section inférieure à la section de la couche sélectrice additionnelle et est entouré d'un espaceur isolant additionnel qui s'étend également sur une portion de la couche sélectrice additionnelle.

L'invention concerne en outre une matrice de mémoires résistives non-volatiles comprenant une pluralité d'ensembles selon l'invention, dans laquelle, pour chaque ensemble :
- l'empilement sélecteur de l'ensemble considéré est relié électriquement à une ligne d'adressage de la matrice,
- les premier et deuxième contacts électriques de l'ensemble sont reliés électriquement, respectivement, à deux colonnes d'adressage distinctes de la matrice, ou forment respectivement deux colonnes d'adressage distinctes de la matrice.

Pour au moins deux desdits ensembles voisins l'un de l'autre, la couche sélectrice de l'un des deux ensembles et la couche sélectrice de l'autre ensemble peuvent former ensemble une même couche sélectrice globale commune aux deux ensembles, d'un seul tenant, et dans laquelle un même via inférieur, commun aux deux ensembles, est relié électriquement à une face inférieure de la couche sélectrice globale.

L'invention concerne également un procédé de fabrication d'un ensemble comprenant au moins deux mémoires résistives non volatiles associées à un sélecteur, comprenant :
- la formation d'un empilement sélecteur comprenant :
   - le dépôt d'une couche sélectrice s'étendant parallèlement à un plan ; et
   - le dépôt d'une électrode supérieure de sélecteur s'étendant sur la couche sélectrice, l'électrode supérieure étant délimitée latéralement par une surface latérale ;
- la formation d'un premier empilement mémoire et d'un deuxième empilement mémoire comprenant :
   - le dépôt conforme d'une couche active globale sur l'empilement sélecteur, une première partie au moins de la couche active globale s'étendant contre une partie de la surface latérale de l'électrode supérieure de sélecteur et une deuxième partie au moins de la couche active globale s'étendant contre une autre partie de la surface latérale de l'électrode supérieure de sélecteur ;
   - la séparation de la couche active globale en au moins une première couche active et une deuxième couche active disjointes,
   - une partie au moins de la première couche active s'étendant de manière oblique, ou même perpendiculaire par rapport audit plan , et contre la partie de la surface latérale de l'électrode supérieure de sélecteur ; et une deuxième partie au moins de la deuxième couche active s'étendant de manière oblique, ou même perpendiculaire par rapport audit plan, et contre l'autre partie de la surface latérale de l'électrode supérieure de sélecteur ;
   - l'électrode supérieure de sélecteur étant commune aux premier et deuxième empilements mémoire ;
- la formation d'un premier contact électrique et d'un deuxième contact électrique, isolés électriquement l'un de l'autre, la première couche active étant connectée électriquement entre, le premier contact électrique d'une part, et, l'électrode supérieure de sélecteur d'autre part, la deuxième couche active étant connectée électriquement entre, le deuxième contact électrique d'une part, et, l'électrode supérieure de sélecteur d'autre part.

Les caractéristiques optionnelles, présentées plus haut en termes de dispositif (pour l'ensemble décrit ci-dessus), peuvent aussi s'appliquer au procédé qui vient d'être présenté.

L'invention et ses différentes applications seront mieux comprises à la lecture de la description qui suit et à l'examen des figures qui l'accompagnent.

### BRÈVE DESCRIPTION DES FIGURES

Les figures sont présentées à titre indicatif et nullement limitatif de l'invention. Sauf précision contraire, un même élément apparaissant sur des figures différentes est repéré par le même signe de référence.
[Fig.1] représente schématiquement un premier mode de réalisation d'un ensemble comprenant au moins deux mémoires résistives non volatiles associées à un sélecteur selon l'invention.
[Fig.2] représente schématiquement un mode de réalisation d'une matrice d'ensembles de ce type.
[Fig.3] représente schématiquement un deuxième mode de réalisation de l'ensemble, qui ne fait pas parti de l'invention.
[Fig.4] représente schématiquement un troisième mode de réalisation de l'ensemble selon l'invention.
[Fig.5] représente schématiquement un quatrième mode de l'ensemble selon l'invention.
[Fig.6a] et [Fig.6b] représentent schématiquement, selon une coupe et une vue de dessus, une première étape d'un procédé de fabrication de l'ensemble selon l'invention.
[Fig.7a] et [Fig.7b] représentent schématiquement, selon une coupe et une vue de dessus, une deuxième étape du procédé de fabrication de l'ensemble selon l'invention.
[Fig.8a] et [Fig.8b] représentent schématiquement, selon une coupe et une vue de dessus, une troisième étape du procédé de fabrication de l'ensemble selon l'invention.
[Fig.9a] et [Fig.9b] représentent schématiquement, selon une coupe et une vue de dessus, une quatrième étape du procédé de fabrication de l'ensemble selon l'invention.
[Fig.10a] et [Fig.10b] représentent schématiquement, selon une coupe et une vue de dessus, une cinquième étape du procédé de fabrication de l'ensemble selon l'invention.
[Fig.11a] et [Fig.11b] représentent schématiquement, selon une coupe et une vue de dessus, une sixième étape du procédé de fabrication de l'ensemble selon l'invention.

### DESCRIPTION DÉTAILLÉE

L'invention concerne un ensemble comprenant au moins deux mémoires résistives non-volatiles associées à un sélecteur, 1a, 1b, 1c, 1d. L'ensemble 1a, 1b, 1c, 1d selon l'invention permet de limiter le problème de variabilité des caractéristiques électriques des sélecteurs mentionné plus haut tout en présentant un encombrement réduit.

Pour cela, selon un premier aspect, l'ensemble 1a, 1b, 1c, 1d mutualise un empilement sélecteur 10 (en l'occurrence, un empilement sélecteur de type « backend », co-intégrable en série avec la ou les mémoires, dans le BEOL) avec au moins deux empilements mémoire 20, 30 distincts, disposés électriquement en parallèle entre eux et connectés en série à l'empilement sélecteur 10 commun. Cet agencement, de type 1SnR (avec n supérieur ou égal à 2, n étant par exemple pair), permet de limiter l'influence de la variabilité entre sélecteurs, puisque c'est le même sélecteur qui est employé pour plusieurs mémoires. D'un point de vue électrique, les deux empilements mémoire 20, 30 sont en quelque sorte, disposés en parallèle entre eux, puisque, d'un côté, ils sont tous deux reliés à conducteur électrique commun (à une borne commune, en quelque sorte), qui est l'électrode supérieure de sélecteur. On notera néanmoins que, de l'autre côté, ces deux empilements mémoire 20, 30 sont reliés à des contacts électriques (50 et 60) distincts, isolés électriquement l'un de l'autre.

L'empilement sélecteur 10, planaire, « horizontal », s'étend parallèlement à un plan P donné. Il comprend au moins :
- une couche sélectrice (11), qui s'étend parallèlement au plan P ; et
- une électrode supérieure de sélecteur 12 s'étendant sur la couche sélectrice 11, l'électrode supérieure étant délimitée latéralement par une surface latérale 121, 122.

Selon un deuxième aspect de l'invention, pour chacun des deux empilements mémoire 20, 30 de l'ensemble 1a, 1b, 1c, 1d :
- une partie au moins du premier empilement mémoire 20 de l'ensemble 1a, 1b, 1c, 1d s'étend de manière oblique, ou même perpendiculaire, par rapport au plan P en question, et contre une partie de la surface latérale 121 de l'électrode supérieure de sélecteur 12, et
- une partie au moins du deuxième empilement mémoire 30 de l'ensemble 1a, 1b, 1c, 1d s'étend de manière oblique, ou même perpendiculaire, par rapport au plan P, et contre une autre partie de la surface latérale 122 de l'électrode supérieure de sélecteur 12.

Cette structure remarquable rend l'ensemble, de type 1SnR (par exemple, de type 1S2R) particulièrement compact.

Dans la suite, on désignera par planaire, ou horizontale une orientation parallèle audit plan P (par exemple parallèle à mieux que 5 degrés prés). Le plan P est question est par exemple parallèle à un substrat sur lequel l'ensemble 1a, 1b, 1c, 1d est réalisé. On indiquera par oblique, une orientation présentant un angle supérieur à 45° par rapport au plan P ou autrement dit, une orientation présentant un angle de 90° ± 45° par rapport au plan P. Et l'on indiquera par verticale (ou perpendiculaire au plan P) une orientation présentant un angle de 90 degrés (par exemple à plus ou moins 5 degrés près) par rapport au plan P. En l'occurrence, dans les exemples décrits ici en référence aux figures, une partie au moins des premier et deuxième empilements mémoire 20, 30 s'étend verticalement (perpendiculairement au plan P). En variante, chacun de ces deux empilements pourrait toutefois être orienté différemment, en s'étendant par exemple parallèlement à un plan faisant un angle de 60 degrés avec ledit plan P horizontal (ou, plus généralement, un angle compris entre 60 et 80 degrés, par exemple).

Ici, la partie du premier empilement mémoire 20, mentionnée plus haut, qui s'étend contre la partie de la surface latérale 121 de l'électrode supérieure de sélecteur 12, s'étend parallèlement (parallèlement à mieux que 5 ou 10 degrés, par exemple) et en vis-à-vis de cette partie de surface latérale 121.

De même, la partie du deuxième empilement mémoire 30, mentionnée plus haut, qui s'étend contre l'autre partie de la surface latérale 122 de l'électrode supérieure de sélecteur 12, s'étend parallèlement (parallèlement à mieux que 5 ou 10 degrés, par exemple) en vis-à-vis de cette autre partie de surface latérale 122.

Dans l'ensemble 1a, 1b, 1c, 1d, les différentes couches (dont les électrodes) qui s'étendent parallèlement au plan P sont délimitées latéralement, chacune, par une (ou éventuellement des) surface latérale, verticale, ou tout au moins oblique par rapport au plan P. Les parties de cette surface latérale sont aussi appelées flanc ou « flancs » dans la suite. Dans la suite, pour certaines couches, il est indiqué que la couche considérée est délimitée latéralement par une surface latérale comprenant notamment deux parties (i.e. : par un premier et deuxième flanc, ici), en pratique situées à l'opposé l'une de l'autre. La surface latérale en question peut néanmoins être continue, et faire tout le tour de l'électrode sans discontinuité, par exemple lorsque le bord de cette couche est circulaire (cette surface latérale étant alors cylindrique) ; dans ce cas, les deux portions en question correspondent à deux portions de cette surface continue, situées à l'opposée l'une de l'autre. Ces deux parties de surface latérale peuvent aussi correspondre à deux faces distinctes du pourtour de la couche en question, opposée l'une à l'autre, lorsque ce pourtour est par exemple rectangulaire (rectangulaire vu du dessus de la couche).

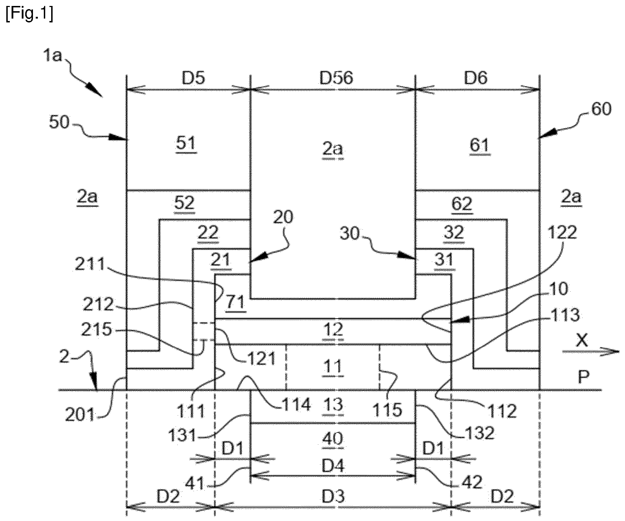

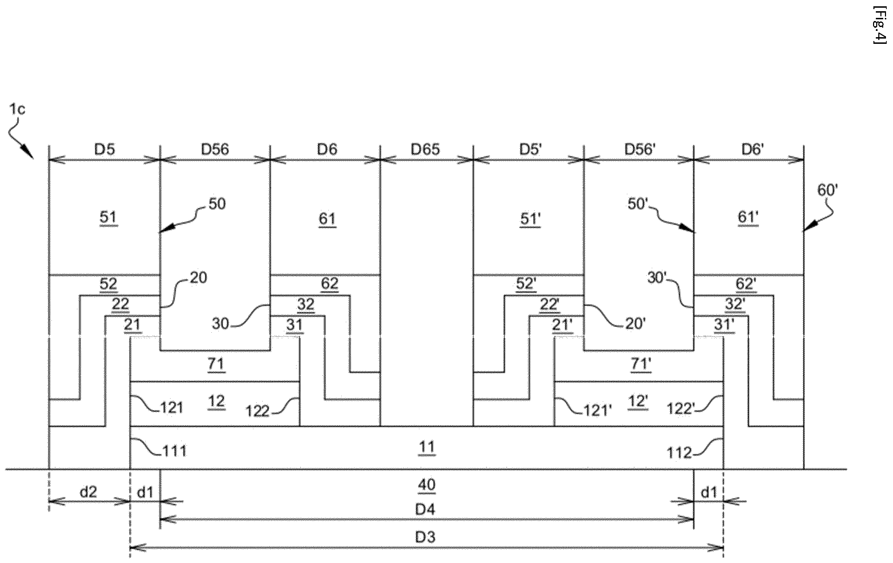

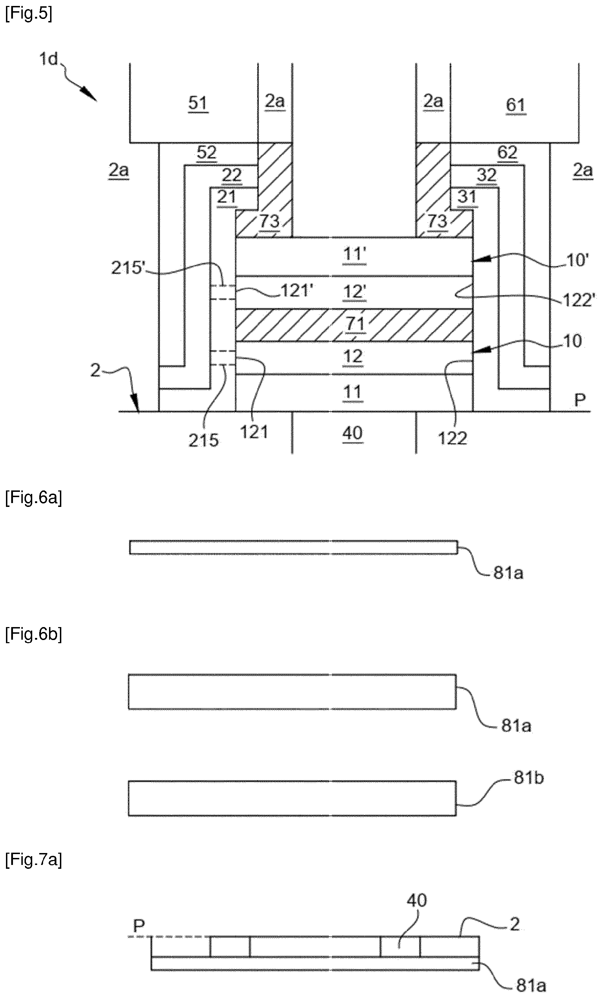

Quatre modes de réalisation de l'ensemble de mémoires 1a, 1b, 1c, 1d selon l'invention sont décrits, respectivement en référence aux [Fig.1], [Fig.4] et [Fig.5]. Quel que soit le mode de réalisation considéré, l'ensemble 1a, 1b, 1c, 1d comprend, un premier 50 et un deuxième 60 contact électrique, en plus de l'empilement sélecteur 10. La [Fig.1] représente schématiquement, en coupe et vu de côté, un premier mode de réalisation de l'ensemble 1a.

Dans cet exemple, le plan P correspond à la surface d'une couche diélectrique 2 sur laquelle l'ensemble repose (on notera toutefois que, à la fin de la fabrication, la couche diélectrique 2 peut faire partie d'un enrobage diélectrique global, de protection, dans lequel l'ensemble est enrobé).

L'électrode supérieure de sélecteur 12 s'étend sur la couche sélectrice 11. La couche sélectrice 11 est délimitée par une surface supérieure 113 et une surface inférieure 114, opposée à la surface supérieure 113. L'électrode supérieure de sélecteur 12 s'étend par exemple sur la surface supérieure 113 de la couche sélectrice 11, contre celle-ci. La surface inférieure 114 de la couche sélectrice 11 repose par exemple, au moins en partie, sur la couche diélectrique 2, parallèlement au plan P.

L'électrode supérieure de sélecteur 12 est délimitée latéralement par la surface latérale 121, 122 mentionnée plus haut, comprenant une première partie 121 et une deuxième partie 122, appelées premier flanc 121 et deuxième flanc 122 dans la suite. Les premier et deuxième flancs 121, 122 sont sensiblement perpendiculaires au plan P. L'électrode supérieure de sélecteur peut, comme ici, avoir une forme d'ensemble rectangulaire. Elle est alors délimitée latéralement par quatre parties ou « flancs » (dont les premier et deuxième flancs 121, 122 en question), correspondant aux quatre côtés de ce rectangle.

La couche sélectrice 11 est délimitée latéralement, elle aussi, par une surface latérale 111, 112, comprenant elle aussi des première et deuxième parties 111, 112, appelées troisième flanc et quatrième flanc dans la suite. Les troisième et quatrième flancs 111, 112 sont opposés l'un à l'autre. Ils peuvent également être situés dans le prolongement des premier et deuxième flancs 121, 122 de l'électrode supérieure de sélecteur 12 ; dans ce cas, le premier flanc 121 (de l'électrode supérieure de sélecteur), et le troisième flanc 111 (de la couche sélectrice) forment un même flanc, global, de l'empilement sélecteur 11 dans son ensemble (résultant d'une gravure de l'ensemble de l'empilement sélecteur); de même, les deuxième et quatrième flancs 122, 112 forment alors un autre flanc, global, de l'empilement sélecteur dans son ensemble. Ici, la couche sélectrice 11 a elle aussi une forme d'ensemble rectangulaire.

Afin que l'empilement sélecteur 10 réalise une fonction de sélection, la couche sélectrice 11 est configurée pour modifier sa conductivité en fonction d'une tension appliquée entre ses surfaces supérieure et inférieure 113, 114, et/ou en fonction d'un courant électrique circulant entre ces surfaces 113, 114. On définit une tension seuil au-delà de laquelle la couche sélectrice 11 est dans un état dit « passant ». C'est à dire qu'une partie au moins de la couche sélectrice 11 est alors conductrice. Par conductrice, on entend que sa résistance est inférieure à 10 kΩ. En deçà de la tension seuil, la couche sélectrice 11 est dans un état dit « bloqué ». C'est à dire que la résistance de la couche sélectrice 11 est supérieure ou égale à 100 kΩ au moins. L'état passant est préférentiellement métastable. C'est à dire que la couche sélectrice 11 est initialement dans l'état bloqué et qu'elle ne présente un état passant que lorsqu'une tension appliquée entre ces surfaces supérieure et inférieure 113, 114 devient supérieure à la tension seuil. La couche sélectrice 11 peut conserver un état passant tant qu'un courant circulant dans ladite couche 11 ou une tension appliquée à ladite couche 11 est supérieure à un courant/tension de maintien donné (en fonction de la technologie du sélecteur).

La couche sélectrice 11 comprend par exemple un chalcogénure, par exemple un alliage à base de sélénium, germanium, antimoine et azote. Auquel cas, l'empilement sélecteur 10 est alors un sélecteur ovonique ou « Ovonic Threshold Switching » en anglais.

La couche sélectrice 11 peut également comprendre un matériau tel que l'empilement sélecteur 10 soit un sélecteur à pont conducteur instable ou **TS** pour « Threshold Switch » en anglais, ou un sélecteur à conduction électronique et ionique ou MIEC pour « Mixed ion-electronic conduction » en anglais ou encore un sélecteur à transition métal-isolant.

L'électrode supérieure de sélecteur 12 est conductrice. Elle comporte une ou plusieurs couches, parallèles au plan P. L'une de ces couches peut être métallique. Une autre de ces couches peut former une barrière à la diffusion d'espèces dans la couche sélectrice 11 par exemple lors d'étapes de procédés postérieures à la formation de ladite couche 11. En effet, certaines étapes pouvant provoquer une oxydation de ladite couche 11. À titre d'exemple, cette électrode peut comprendre une couche en carbone intercalée entre une couche en nitrure de titane et la couche sélectrice 11.

Dans ce premier mode de réalisation (ainsi que dans les deuxième et quatrième modes de réalisation), l'électrode supérieure de sélecteur 12 s'étend sur toute la surface supérieure 113 de la couche sélectrice 11, ou tout au moins sur la majeure partie de cette surface supérieure 113, en particulier au niveau d'une portion centrale 115 de la couche sélectrice 11 (portion centrale 115 située à l'aplomb d'un via inférieur 40).

Le premier empilement mémoire 20 permet de stocker une information de manière non volatile. L'information est par exemple encodée sous la forme d'une valeur de résistance d'une couche active dudit premier empilement mémoire 20. Le premier empilement mémoire 20 peut être de type de PCRAM, CBRAM, OxRAM ou MRAM telle que décrit dans lors de la présentation de l'art antérieur. Le premier empilement mémoire 20 comprend pour cela au moins une première couche active 21. La première couche active 21 peut présenter un état dit « bas », c'est à dire une résistance faible, par exemple inférieure à 10 kΩ, ou un état dit « haut », c'est à dire une résistance élevée, par exemple supérieure à 50 kΩ. La première couche active 21 passe de l'état haut à l'état bas lorsqu'une tension, appliquée à cette couche, dépasse une tension de programmation, dite également tension de « set » en anglais. La première couche active 21 passe de l'état bas à l'état haut lorsqu'une tension ou un courant appliqué à la couche dépasse une tension ou un courant d'effacement (selon la technologie mise en œuvre), dite également tension/courant de « reset » en anglais. La première couche active 21 comprend par exemple une couche d'oxyde d'hafnium (en contact avec une couche en titane faisant office de réservoir à lacunes en oxygène), auquel cas le premier empilement mémoire 20 réalise la fonction d'OxRAM.

De la même manière, le deuxième empilement mémoire 30 comprend au moins une deuxième couche active 31, permettant d'encoder une information sous la forme d'une valeur de résistance. Les caractéristiques électriques des première et deuxième couches actives 21, 31, dont au moins les tensions de programmation et d'effacement, sont proches, voire identiques.

La réduction de l'encombrement de l'ensemble 1a résulte notamment du partage du même plot sélecteur pour les deux mémoires, et de l'orientation oblique (par rapport au plan P), et préférentiellement verticale, d'une partie au moins de la première couche active 21.

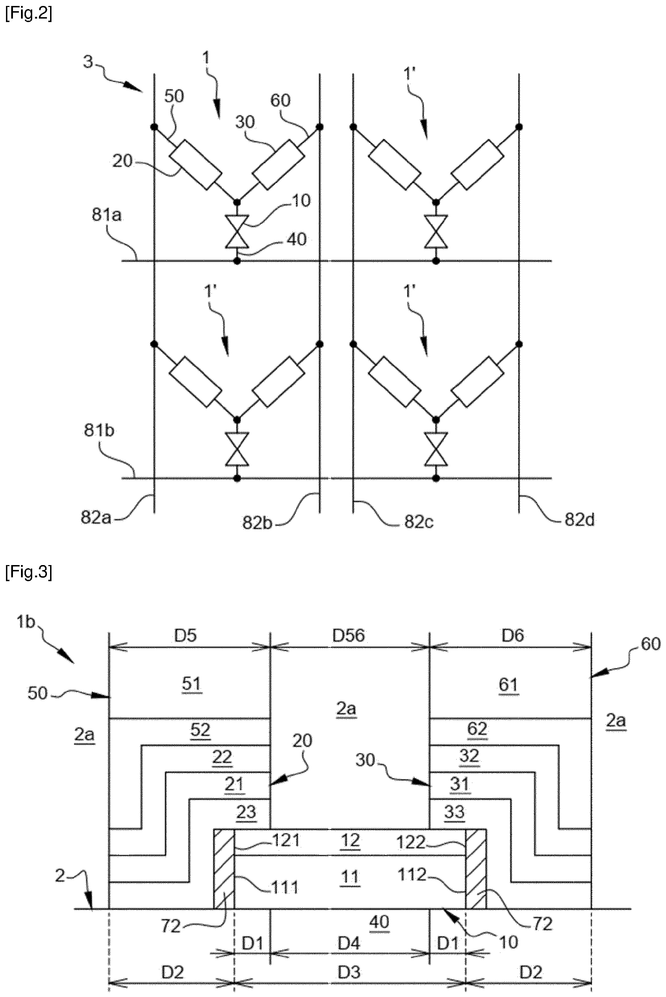

La première couche active 21 est connectée électriquement entre le premier contact électrique 50 et l'électrode supérieure de sélecteur 12. De la même manière, la deuxième couche active 31 est connectée électriquement entre le deuxième contact électrique 60 et l'électrode supérieure de sélecteur 12. Ainsi, l'électrode supérieure de sélecteur 12 est commune aux premier et deuxième empilements mémoire 20, 30. En d'autres termes, c'est la même électrode 12 qui connecte électriquement la couche sélectrice 11, d'une part à la première couche active 21, et d'autre part à la deuxième couche active 31. Les première et deuxième couches actives 21, 31 sont donc reliées électriquement l'une à l'autre par cette même électrode 12 conductrice, planaire. Cette électrode joue donc en quelque sorte un rôle de point milieu, entre les deux mémoires, d'un point de vue électrique (voir le schéma électrique équivalent de la figure 2). Les premier et deuxième contacts 50, 60 sont en revanche isolés électriquement l'un de l'autre.

Par isolés électriquement, on entend sans contact électrique direct entre eux. En d'autres termes, il n'y a pas d'élément conducteur, par exemple métallique, les reliant directement.

L'ensemble 1a peut être enterré dans un oxyde de remplissage isolant 2a pouvant être un oxyde de silicium ou de la silice.

La variabilité des caractéristiques électriques de l'empilement sélecteur 10 peut être causée par des étapes de fabrication dudit empilement 10 ou des empilements mémoires 20, 30 introduisant des défauts dans une partie de la couche sélectrice 11. Les défauts sont généralement localisés au niveau de la surface latérale de la couche sélectrice 11 et notamment au niveau des troisième et quatrième flancs 111, 112, exposés à des étapes de gravure ou de dépôt. Les caractéristiques électriques au niveau de ces flancs sont alors modifiées localement. Il est alors prévu d'éloigner les troisième et quatrième flancs 111, 112 l'un de l'autre, pour qu'ils soient séparés par une distance D3 supérieure à une largeur D4 du via 40 qui connecte électriquement l'empilement sélecteur 10, en partie inférieure. En d'autres termes, la couche sélectrice 11 est disposée à l'aplomb du via inférieure 40 (c'est-à-dire qu'elle se superpose, au moins en partie, au via inférieur, en projection selon une direction verticale ; voire elle est alignée avec ce via, selon une direction verticale) et elle présente une distance D3, par exemple une largeur, supérieure à la largeur D4 du via inférieure 40. C'est alors au niveau d'une portion centrale 115 de la couche sélectrice 11 que cette couche devient conductrice, lorsque le sélecteur bascule à l'état passant. Autrement formulé, c'est seulement au niveau de cette portion centrale 115 que la couche sélectrice 11 est utilisée, d'un point de vue électrique. Et comme D3 est supérieure à D4, cette portion centrale 115 est éloignée des flancs 111, 112 de la couche sélectrice 11, et est donc peu ou pas influencée par les caractéristiques électriques au niveau des flancs 111, 112, possiblement dégradées par des opérations de gravure ou de dépôt des empilements mémoire. La portion centrale 115 de la couche sélectrice 11 présente ainsi une variabilité minimale de ses caractéristiques électriques.

La distance D3 séparant les troisième et quatrième flancs 111, 112 est supérieure à la largeur de la zone active (du canal de conduction) du sélecteur. Elle est par exemple comprise entre 60 nm et 100 nm, voire entre 70 nm et 90 nm. En effet, dans une couche sélectrice 11 ovonique, le canal de conduction métastable peut présenter une étendue planaire pouvant être comprise entre 40 nm et 60 nm, et qui dépasse rarement 80 nm. En augmentant ainsi la distance D3 séparant les troisième et quatrième flancs 111, 112, on réduit la variabilité des caractéristiques électriques de l'empilement sélecteur, fixées par celles du canal de conduction, situé loin des flancs (loin des bords).

L'orientation en partie verticale des premier et deuxième empilements mémoire 20, 30, et l'utilisation d'une couche sélectrice 11 commune, planaire, permet d'écarter les troisième et quatrième flancs 111, 112 l'un de l'autre, comme indiqué ci-dessus, pour réduire les problèmes de variabilité, sans augmenter l'encombrement de l'ensemble 1a, par rapport à des dispositif 1R1S de l'art antérieur, en tout cas du point de vue de l'encombrement selon la direction X représentée sur la figure 1 (direction perpendiculaire aux premier et deuxième flancs). Cet aspect est expliqué plus en détail ci-dessous.

Dans la direction X, chaque empilement mémoire 20, 30 s'étend, à partir de la surface latérale 121, 122 de l'électrode supérieure 12, sur une deuxième distance D2 (dans le premier mode de réalisation, cette distance correspond en quelque sorte à l'épaisseur totale de l'empilement mémoire et de la couche métallique optionnelle 52 qui le recouvre). Par ailleurs, les surfaces latérales de la couche sélectrice 11 et de l'électrode supérieure 12 sont toutes deux décalées latéralement par rapport à une surface latérale 41, 42 du via inférieur 40 d'une première distance D1 non nulle. En d'autres termes, les flancs 121 et 111 sont tous deux décalés latéralement, par rapport à une portion, dite cinquième flanc 41, de la surface latérale 41, 42 du via inférieur 40de la première distance D1. De même, les flancs 112, 122 sont tous deux décalés latéralement, par rapport à un autre portion, dite sixième flanc 42, de la surface latérale 41, 42 du via inférieur 40, de cette distance D1 (on a donc D3 = D4+2·D1). La distance D1 est préférentiellement comprise entre 10 nm et 30 nm.

En pratique, la largeur D4 du via inférieure est limitée par la finesse de gravure, F (elle est par exemple égale à cette finesse F, pour réduire au maximum les dimensions du via), finesse qui vaut par exemple 40 nm. De même, la largeur D5 et D6 des contacts supérieurs 5 et 6 est limitée par la finesse F, par exemple égale, ou sensiblement égale à F. Ces deux contacts sont séparés par une distance D56 qui est souvent appelée « metal pitch », car elle correspond à la distance entre deux lignes (ou deux colonnes) métalliques de la matrice (en pratique, il s'agit aussi de la distance, selon la direction X, entre deux ensembles 1 adjacents). Le « metal pitch » est ici limité par la finesse F. Il est par exemple égal ou sensiblement égal à F, pour maximiser la densité de la matrice.

Dimensionner l'ensemble de sorte que la somme D1+D2 soit, comme ici, inférieure ou égale à la largeur D5 (largeur selon la direction X) du contact supérieur 50 permet alors de loger sous ce contact le premier empilement mémoire, ainsi que la partie de l'empilement sélecteur 10 qui déborde latéralement au-delà du via inférieur 40. Selon la direction X, l'encombrement de l'ensemble est donc de 2F pour chaque empilement mémoire, comme pour un dispositif 1S1R classique de l'art antérieur, et cela alors même que la couche sélectrice 11 a une extension latérale supérieure à F (pour limiter l'influence indésirables des bords de couche).

Le premier contact électrique 50 est disposé à l'aplomb du premier empilement mémoire 20, en s'étendant latéralement de la surface latérale 41, 42 du via inférieure 40, et plus particulièrement du cinquième flanc 41,à la surface latérale 201 du premier empilement mémoire 20 la plus externe (celle s'étend à la distance D2 du premier flanc 121). Le premier contact électrique 50 est ainsi disposé à l'aplomb de premier flanc 121 de l'électrode supérieure de sélecteur 12 et de chaque surface latérale du premier empilement mémoire 20.

Vue en coupe, la première couche active 21, comprend par exemple une portion verticale et deux portions planaires, à chacune de ses extrémités. Vue en coupe, elle forme ainsi un « S » pouvant être logé sous le premier contact 50, au droit de celui-ci, sans en dépasser d'un point de vue latéral.

Les deux portions planaires de la couche active 21 sont optionnelles. La couche active 21 pourrait être entièrement orientée verticalement et disposée sous le premier contact 50.

De la même manière, la deuxième couche active 31, au moins en partie orientée de manière oblique, voire verticalement, permet à la couche sélectrice 11 et/ou l'électrode supérieur de sélecteur 12 de s'étendre jusque sous le deuxième contact 60 sans pour autant augmenter l'encombrement de l'ensemble (dans la direction X).

La densité de stockage offerte par une matrice de points mémoire dépend en partie de l'espacement imposé entre des lignes d'adressage deux à deux et/ou des colonnes d'adressage deux à deux. Plus cet espacement est faible et plus la densité de stockage de la matrice finale est élevée. Cet espacement, qui correspond à la distance D56 entre les premier et deuxième contact électrique 50, 60, destinés à être connectés aux lignes/colonnes d'adressage, ou qui forment directement ces lignes/colonnes d'adressage, est limité en pratique par la finesse F de gravure.

L'empilement sélecteur 10 est également relié électriquement au via inférieur 40 mentionné plus haut (ou à un autre élément conducteur équivalent). La couche diélectrique 2 sur laquelle repose l'empilement sélecteur 10 est traversée par ce via inférieur 40. Le via inférieure 40 peut ainsi être relié électriquement à la surface inférieure 114 de la couche sélectrice 11, soit directement, en venant directement au contact de cette surface inférieure 114, soit par l'intermédiaire d'une couche ou plusieurs couches intermédiaires (telles que l'électrode inférieure de sélecteur 13 visible sur la figure 1). Ainsi, la couche sélectrice 11 est reliée électriquement en série entre les deux éléments conducteurs que sont l'électrode supérieure de sélecteur 12 et le via conducteur 40. Lorsqu'une tension supérieure à la tension seuil de la couche sélectrice 11, est appliquée entre l'électrode supérieure de sélecteur 12 et le via inférieure 40, l'empilement sélecteur 10 peut ainsi passer de l'état bloqué à l'état métastable passant.

Comme mentionné plus haut, l'empilement sélecteur 10 comprend ici l'électrode inférieure de sélecteur 13, reliée électriquement en série entre la couche sélectrice 11 et le via inférieure 40. L'électrode inférieure 13 s'étend sur une partie au moins de la face inférieure 114 de la couche sélectrice 11. Lorsque la couche sélectrice 11 est de type OTS (ovonique), l'électrode inférieure 13 comprend avantageusement du nitrure de titane ou du carbone. L'électrode inférieure 13 peut également présenter de l'argent, notamment lorsque la couche sélectrice 11 est de type TS (pont à conducteur instable). L'électrode inférieure 13 est ainsi une électrode active et elle permet à la couche sélectrice 11 de changer d'état lorsqu'un potentiel positif est appliqué sur l'électrode inférieure 13. Pour les mêmes raisons, l'électrode inférieure 13 peut présenter du cuivre lorsque l'électrode inférieure 13 est de type MIEC (conduction électronique et ionique),

Ici, l'électrode inférieure 13, conductrice, présente les mêmes dimensions latérales que le via inférieur 40 et est disposée dans le prolongement, au droit de ce dernier. L'extension latérale de l'électrode inférieure 13, réduite par rapport à l'extension latérale, D3, de la couche sélectrice 11 permet, comme discuté plus haut, de limiter la zone utilisée de la couche sélectrice à sa portion centrale 115. L'électrode inférieure 13 est délimitée ici par une surface latérale 131, 132, située dans le prolongement de surface latérale 41, 42 du via 40. Plus particulièrement, deux portions de la surface latérale 131, 132 de l'électrode inférieure 13, dites septième flanc 131 et huitième flanc 132, sont situées dans le prolongement des flancs 41 et 42 du via 40, et en tout cas distants de D1 des flancs 111, 121, 112, 122 de l'empilement.

Le premier empilement mémoire 20 peut, comme ici, comprendre une première électrode supérieure 22. La première électrode supérieure 22 relie électriquement la première couche active 21 au premier contact supérieur 50. Elle est d'ailleurs préférentiellement disposée entre la première couche active 21 et le premier contact supérieur 50. Pour cela, la première électrode supérieure 22 s'étend sur la première couche active 21, contre celle-ci. De manière avantageuse, une partie au moins de la première électrode supérieure 22 s'étend également parallèlement au premier flanc 121 de l'électrode supérieure de sélecteur 12 et en vis-à-vis de ce premier flanc 121. Cette première électrode supérieure 22 peut comprendre une ou plusieurs couches, jouant par exemple un rôle de couche réservoir pour des lacunes en oxygène (une telle couche étant par exemple réalisée en titane), ou un rôle de couche d'isolation s'opposant au passage d'oxygène (couche en nitrure de titane, par exemple), ou jouer encore un autre rôle dans le fonctionnement de l'empilement mémoire 20.

Le premier empilement mémoire 20 peut aussi comprendre une électrode inférieure (non représentée), qui s'étend, parallèlement à la première couche active 21, contre celle-ci, d'un côté opposé à la première électrode supérieure 22. En variante, l'électrode supérieure de sélecteur 11 pourrait jouer à la fois le rôle d'électrode supérieure de sélecteur, et d'électrode inférieure pour chacune des deux couches actives 21, 31 des empilements mémoire.

De la même manière, le deuxième empilement mémoire 30 peut comprendre une deuxième électrode supérieure 32 reliant électriquement la deuxième couche active 31 au deuxième contact supérieur 60, et, une deuxième électrode inférieure.

Le premier contact électrique 50 peut comprendre un premier via supérieur 51 s'étend par exemple à la verticale du premier empilement mémoire 20. Afin d'améliorer le contact électrique entre le premier contact 50 et le premier empilement mémoire 20, celui-ci peut également comprendre une première couche métallique 52, reliant électriquement le premier empilement mémoire 20. La première couche métallique 52 s'étend par exemple en partie sur le premier empilement mémoire 20 en recouvrant une partie verticale et une partie planaire dudit premier empilement mémoire 20. Dans un développement, la première couche métallique 52 joue directement le rôle de première électrode supérieure 22. La première couche métallique 52 pourrait aussi former l'une des colonnes d'adressage de la matrice, le via 51 étant un via de connexion de cette colonne, éventuellement déporté par rapport au dispositif 1a.

De la même manière, le deuxième contact électrique 60 peut comprendre un deuxième via supérieur 61 s'étendant, par exemple, à la verticale du premier empilement mémoire 20. Il peut également comprendre une deuxième couche métallique 62, reliant électriquement le deuxième empilement mémoire 30. La deuxième couche métallique 62 peut également s'étendre sur le deuxième empilement mémoire 30 en recouvrant une partie verticale et une partie planaire.

Comme déjà indiqué, la première couche active 20 est reliée électriquement à l'électrode supérieure de sélecteur 12. Dans le mode de réalisation de la [Fig.1], la première couche active 20 est directement reliée électriquement à l'électrode supérieure de sélecteur 12. Plus précisément, elle vient directement en contact contre le premier flanc 121 cette électrode. Une première surface 211 de la première couche active est ainsi au contact de ce flanc de l'électrode supérieure de sélecteur 12. En variante, une couche électriquement conductrice (telle qu'une électrode inférieure du premier empilement mémoire) pourrait toutefois être intercalée entre la première couche active et ce premier flanc 121 (cette couche conductrice s'étendant contre le premier flanc 121, tandis que la première couche active 21 vient s'étendre contre cette couche conductrice intermédiaire).

Ainsi, la première couche active 21 présente une portion disposée entre la première électrode supérieure 22 et l'électrode supérieure de sélecteur 12. Lorsque la première couche active 21 est par exemple de type OxRAM ou CBRAM, l'application d'une différence de potentiel entre la première électrode supérieure 22 et l'électrode supérieure de sélecteur 12 lors d'une opération initiale de forming (première création d'un filament conducteur) entraîne la formation d'un canal de conduction, dans la première couche active 21, au niveau d'une zone située en face du premier flanc 121 de l'électrode supérieure de sélecteur 12. La position du canal de conduction est donc contrôlée (et, en l'occurrence, elle est elle aussi éloignée des bords - i.e. des extrémités - de la première couche active), permettant de réduire la variabilité du premier empilement mémoire 20.

La première couche active 21 peut comprendre une portion planaire, venant en quelque sorte recouvrir une partie de l'électrode supérieure de sélecteur 12. Afin de conserver la localisation du canal de conduction au niveau du premier flanc 121 de l'électrode supérieure de sélecteur 12, l'ensemble 1a peut alors comprendre une couche isolante 71. Il s'agit par exemple d'une couche en matériau diélectrique, par exemple en nitrure de silicium, tel qu'un masque dur. La couche isolante est au moins disposée entre ladite portion planaire de la première couche active 21 et l'électrode supérieure de sélecteur 12. La couche isolante s'étend par exemple sur la totalité de l'électrode supérieure de sélecteur 12, tel que représenté par la [Fig.1].

La [Fig.3] représente schématiquement un deuxième mode de réalisation de l'ensemble 1b, qui ne fait pas part de l'invention. À la différence du mode de réalisation de la [Fig.1], la première couche active 21 du premier empilement mémoire 20 s'étend contre le premier flanc 121 de l'électrode supérieure de sélecteur 12 mais n'est pas directement en contact avec le premier flanc 121 .

En effet, dans ce deuxième mode de réalisation, l'ensemble 1b comprend en outre un espaceur 72 électriquement isolant, qui s'étend contre le premier flanc 121, de l'électrode supérieure de sélecteur 12, et contre le troisième flanc 111, de la couche sélectrice 11. Cet espaceur 72 permet de protéger les flancs en question, notamment lors des opérations de dépôt et gravure des empilements mémoire 20, 30. Cela permet de réduire encore la variabilité des caractéristiques électrique de l'empilement sélecteur 10. Cet espaceur 72 est situé entre une partie de la première couche active 21 et les premier et troisième flancs 121, 111. Il est en quelque sorte pris en sandwich entre le flanc de l'empilement sélecteur et la partie verticale de la première couche active). Il s'étend contre les flancs 111 et 121, et la partie verticale de la première couche active s'étend contre cet espaceur 72.

Cet espaceur fait tout le tour de l'empilement sélecteur 10, et s'étend donc aussi entre, d'une part, les deuxième et quatrième flancs 122, 112, et, d'autre part, la deuxième couche active 31.

Par ailleurs, dans ce deuxième mode de réalisation, le premier empilement 20 comprend une première électrode inférieure 23 reliant électriquement la première couche active 21 à l'électrode supérieure de sélecteur 12. La première électrode inférieure 23 s'étend contre la première couche active 21, par exemple sur une face de la couche active 21 opposée la première électrode supérieure 22. Ainsi, la première couche active 21 est disposée entre (en quelques sorte prise entre) les premières électrodes supérieure et inférieure 22, 23. Selon ce mode de réalisation, la première électrode inférieure 23 est reliée directement à l'électrode supérieure de sélecteur 12. Les premières électrodes supérieure et inférieure 22, 23 distribuent les lignes de champs de manière homogène dans la couche active 21. Le canal de conduction peut donc être formé à une position dans la couche active 21, pas nécessairement en vis-à-vis du premier flanc 121, de l'électrode supérieure 12. La première électrode inférieure 23 peut être connectée à un flanc de l'électrode supérieure de sélecteur 12 ou, comme ici, sur une face supérieure de l'électrode supérieure de sélecteur 12, tel que présenté par la [Fig.3].

La [Fig.4] représente schématiquement, en une coupe, un troisième mode de réalisation de l'ensemble 1c. À la différence du mode de réalisation de la [Fig.1], l'ensemble 1c comprend des troisième et quatrième empilements mémoire 20', 30', connectés à une même électrode supérieure de sélecteur additionnelle 12'. Les premier, deuxième, troisième et quatrième empilements mémoire 20, 30, 20', 30' sont par exemple alignés dans un même plan, par exemple celui de la [Fig.4]. Les troisième et quatrième empilement mémoires 20', 30' peuvent, pour l'essentiel, présenter les mêmes caractéristiques que les premier et deuxième empilements mémoire de la [Fig.1].

L'électrode supérieure de sélecteur additionnelle 12' est délimitée par une surface latérale dont une première et deuxième parties 121', 122', opposées l'une à l'autre, sont appelées flancs additionnels 121', 122'. L'électrode supérieure de sélecteur additionnelle 12' est distincte de l'électrode supérieure de sélecteur 12, sans contact cette dernière (c'est-à-dire disjointe de l'électrode supérieure de sélecteur 12, et donc, notamment, sans contact électrique direct avec elle). Le troisième empilement mémoire 20' comprend une troisième couche active 21' qui s'étend parallèlement au premier flanc additionnel 121' et en vis-à-vis de celui-ci. Le quatrième empilement mémoire 30' comprend une quatrième couche active 31' qui s'étend parallèlement au deuxième flanc additionnel 122', également en vis-à-vis de celui-ci.

La couche sélectrice 11 est commune aux deux électrodes supérieures de sélecteur 12, 12', et s'étend sous chacune d'elles. Les première et quatrième couches actives 21, 31' des premier et quatrième empilements mémoire 20, 30' s'étendent également respectivement en vis-à-vis des troisième et quatrième flancs 111, 112 de la couche sélectrice 11 (sur toute la hauteur de l'empilement sélecteur 10)

En revanche, les deuxième et troisième couches actives 31, 21' ne sont pas en vis-à-vis de flancs de la couche sélectrice 11 (puisque la couche sélectrice 11 s'étend latéralement bien au-delà du deuxième flanc 122 de l'électrode supérieure 12, et au-delà aussi du premier flanc additionnel 121'). La couche sélectrice 11 s'étend sous les deuxième et troisième empilements mémoires 30, 20'.

La mutualisation de la même couche sélectrice 11 pour quatre empilements mémoire 20, 30, 20', 30' permet d'obtenir une distance D4 importante séparant les troisième et quatrième flancs 111, 112 de la couche sélectrice 11. La variabilité étant améliorée avec l'augmentation de la distance D4 séparant lesdits flancs 111, 112, l'empilement sélecteur 10 présente une variabilité améliorée.

Le via inférieur 40 s'étend en partie au droit des deux électrodes supérieures de sélecteur 12, 12' de manière à pouvoir créer un canal de conduction sous chacune desdites électrodes supérieure de sélecteur 12, 12'. Là aussi, les flancs 111, 112 de la couche sélectrice 11 sont séparés par la distance D3, supérieure à la largeur D4 du via inférieur 40 (et même, plus précisément égale à D3 + 2·D1).

On notera que deux canaux de conduction indépendant sont formés dans cette même couche sélectrice 11, l'un sensiblement au droit de l'électrode supérieure 12, et l'autre sensiblement au droit de l'électrode supérieure additionnelle 12'. L'ensemble 1c est donc en quelque sorte de la forme « 2S4R ».

L'ensemble comprend également un troisième contact électrique 50' et un quatrième contact électrique 60'. De la même manière que les premier et deuxième contacts électriques 50, 60, les troisième et quatrième contacts 50', 60' sont également isolés électriquement l'un de l'autre.

La troisième couche active 21' est reliée électriquement entre, le troisième contact 50' et l'électrode supérieure de sélecteur additionnelle 12'. La quatrième couche active 22' est reliée électriquement entre le quatrième contact 60' et l'électrode supérieure de sélecteur additionnelle 12'.

La [Fig.5] représente schématiquement un quatrième mode de réalisation de l'ensemble 1d. L'ensemble 1d comprend une empilement sélecteur additionnel 10'. L'empilement sélecteur 10 et l'empilement sélecteur additionnel 10' sont orientés en tête-bêche et séparés l'un de l'autre par une couche isolante 71.

L'empilement sélecteur additionnel 10' comprend une couche sélectrice additionnel 11' et une électrode supérieure de sélecteur additionnelle 12'. L'ensemble 1d comprend également la couche isolante 71 s'étendant entre les empilements sélecteur 10 et 10' de manière à les isoler électriquement l'un de l'autre. L'électrode supérieure 12 et l'électrode de sélecteur additionnel 12' sont en vis-à-vis l'une de l'autre, séparé par la couche isolante 71. La couche sélectrice additionnelle 11' s'étend sur l'électrode de sélecteur additionnel 12', contre celle-ci.

L'empilement sélecteur 10 est relié électriquement à un via inférieur 40. L'empilement sélecteur 10' peut également être relié électriquement à un via 40', appelé supérieur ou via de sélecteur additionnel, situé au-dessus de la couche sélectrice additionnelle 11'. Ici, le via supérieur 40' vient au contact de la couche sélectrice additionnelle 11', contre celle-ci. Le via supérieur 40' est disposé entre les premier et deuxième contacts électriques 50, 60, d'un point de vue latéral.

L'électrode de sélecteur additionnel 12' présente également une surface latérale 121', 122' dont deux parties, appelées flancs additionnels, sont orientées de manière oblique, voire verticalement. Les flancs additionnels 121', 122' de l'électrode de sélecteur additionnel 12' sont parallèles aux premier et deuxième flancs 121, 122 de l'électrode supérieure 12, ici. Chacun des flancs additionnels 121', 122' est préférentiellement aligné avec respectivement les premier ou deuxième flancs de l'électrode supérieure 12, situés dans le prolongement de ceux-ci. En pratique, l'empilement global formé par l'empilement sélecteur 10, la couche isolante 71 et l'empilement sélecteur additionnel 10' qui vient la recouvrir, peut être délimité latéralement lors d'une même opération de gravure, globale, produisant, une même surface latérale globale, d'ensemble, qui s'étend sur toute la hauteur de cet empilement global (et cela sur chaque côté, ou sur chaque flanc de cet empilement global).

La première couche active 21 du premier empilement mémoire 20 s'étend verticalement sur toute une partie de la hauteur de cet empilement global (ici, sur toute la hauteur de cet empilement global, et même plus). Elle s'étend non seulement en vis-à-vis du premier flanc 121 de l'électrode supérieure de sélecteur 12, mais aussi en vis-à-vis du premier flanc additionnel 121', de l'électrode de sélecteur additionnel 12', parallèlement à ces flancs 121, 121'. De cette manière, la couche active 21 du premier empilement mémoire peut comprendre deux canaux de conduction 215, 215' distincts (l'un, 215, situé en face du premier flanc 121, et l'autre, 215', situé en face du premier flanc additionnel 121'), adressables indépendamment l'un de l'autre, permettant d'encoder chacun une information distincte. Une seule couche active 21 permet ainsi de former deux « mémoires » distincts.

La première couche active 21 est en partie orientée verticalement et libère ainsi un espace pouvant être occupé par chacune des couches sélecteur 11, 11'. De la sorte, chaque couche sélectrice 11, 11' voit sa variabilité réduite.

De même que la première couche active 21, la deuxième couche active 31 s'étend verticalement sur toute une partie de la hauteur de l'empilement global en question (ici, sur toute la hauteur de cet empilement global, et même plus). Elle s'étend non seulement en vis-à-vis du deuxième flanc 122 de l'électrode supérieure de sélecteur 12, mais aussi en vis-à-vis du premier flanc additionnel 122', de l'électrode de sélecteur additionnel 12', parallèlement à ces flancs 122, 122'.

Le via supérieur 40' est isolé de chaque empilement mémoires 20, 30. Il est par exemple isolé au moyen d'espaceurs isolants additionnels 73 entourant le via supérieur 40'. Le via supérieur 40' a une largeur ou une section plus petite que l'extension latérale, ou la section de la couche sélectrice additionnelle 11' (comme pour le via inférieur 40 et la couche sélectrice 11), de manière à n'utiliser la couche sélectrice additionnelle 11' que dans une zone centrale de cette couche. L'espaceur isolant additionnel 73 s'étend alors également sur une portion de la couche électrode additionnelle 11'.

La [Fig.2] représente un schéma électrique équivalent de l'ensemble 1 tel que décrit en référence au [Fig.1] et [Fig.3]. La [Fig.2] représente de manière plus large une matrice 3 comprenant plusieurs ensembles 1, 1', préférentiellement identiques, connectés entre deux lignes d'adressage 81a, 81b et quatre colonnes d'adressage 82a, 82b, 82c, 82d. L'ensemble 1 tel que décrit précédemment est notamment connecté entre une ligne 81a et deux colonnes 82a, 82b.

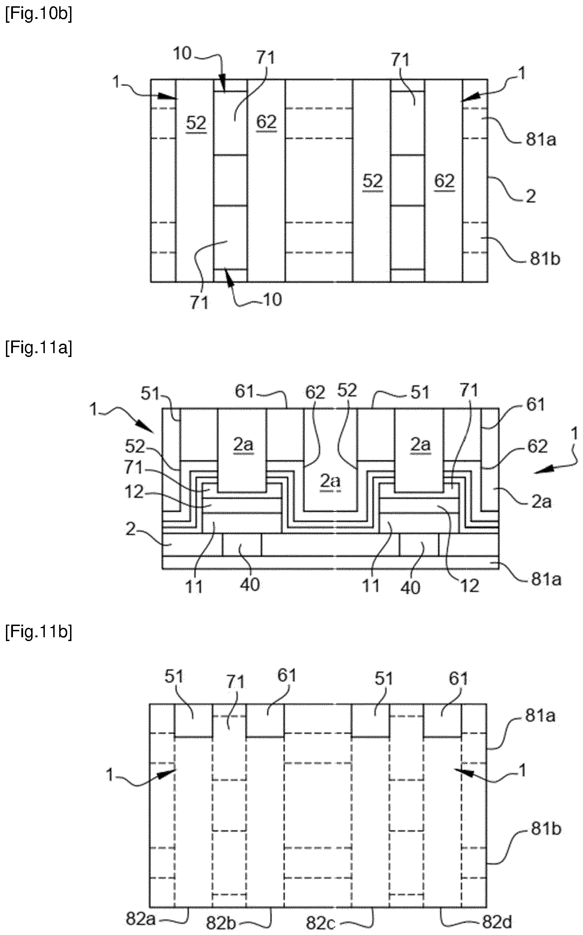

Le schéma électrique de l'ensemble 1 comprend trois branches connectées à un nœud commun (correspondant à l'électrode supérieure de sélecteur), formant ainsi un Y. Une première branche comprend l'empilement sélecteur 10, relié en série entre ledit nœud commun et une ligne d'adressage 81a. Il est par exemple relié à la ligne d'adressage 81a au moyen du via inférieur 40. Une deuxième branche comprend le premier empilement mémoire 20. Le premier empilement mémoire 20 est relié en série entre ledit nœud et une première colonne d'adressage 82a. La colonne d'adressage est formée par ici par les couches conductrices 22 et 52, qui, à l'échelle de la matrice 3, ont une forme de bande allongée (voir la figure 10b) qui s'étend sur toute la largeur de matrice. Le premier empilement mémoire est par exemple relié à ladite première colonne d'adressage 82a au moyen du premier contact électrique 50, situé en bout de colonne (au bout de la colonne 82a). Une troisième branche comprend le deuxième empilement mémoire 30. Le deuxième empilement mémoire 30 est également relié en série entre ledit nœud et une deuxième colonne d'adressage 82b (formée ici par les couches conductrices 32 et 62, de manière comparable à la colonne d'adressage 81a). Le deuxième empilement mémoire 30 est par exemple relié à la deuxième colonne d'adressage 82b au moyen du deuxième contact électrique 60.

La matrice 3 tire avantage du mode de réalisation de la [Fig.4]. Au moins deux ensembles 1, 1' voisins l'un de l'autre et connectés à la même ligne de d'adressage 81a peuvent avantageusement partager une seule et même couche sélectrice 11, s'étendant sous chaque électrode supérieure 12 de chaque ensemble 1, 1'. En pratique les couches sélectrices 11 de chaque ensemble 1, 1' forment ensemble une même couche sélectrice globale, commune à chaque ensemble. La couche sélectrice globale est avantageusement connectée à un même via inférieur 40, commun à chaque ensemble et relié électriquement à une face inférieure de la couche sélectrice globale 11.

Le [Table 1] ci-dessous présente un schéma de polarisation en tension des lignes et colonnes d'adressage 81a-b, 82a-d pour réaliser les opérations de programmation d'un état bas (SET), ou d'effacement (écriture d'un état haut, ou RESET) dans chacun des premier et deuxième empilements mémoires 20, 30. La valeur de la tension U appliquée est choisie de sorte que :
- U soit supérieur aux tensions de programmation et d'effacement de chaque circuit 1S1R de l'ensemble ; et
- U/2 soit inférieur à la tension de seuil de l'empilement sélecteur 10.

Le terme « Flottant » signifie que la ligne ou colonne d'adressage est laissée à un potentiel électrique flottant. Entre deux opérations, il peut être avantageux de décharger les lignes et/ou colonnes laissées à un potentiel flottant, par une mise à un potentiel nul.

**[Table 1]**

| Opération | Empilement | 81a | 81b | 82a | 82b | 82c | 82d |
|---|---|---|---|---|---|---|---|
| Programmation | 20 | 0 | | U | Flottant | | |
| | 30 | | U/2 | Flottant | U | U/2 | U/2 |
| Effacement | 20 | U | | 0 | Flottant | | |
| | 30 | | | Flottant | 0 | | |

La lecture de l'état d'un empilement mémoire peut être réalisée en utilisant un schéma de polarisation similaire, ou même identique, mais en choisissant une tension U dans une fenêtre de lecture, inférieure à la tension de programmation et d'effacement de chaque circuit 1S1R de l'ensemble.

L'invention concerne également un procédé de fabrication d'un ensemble 1 tel que décrit précédemment. Un mode de mise en œuvre dudit procédé est décrit en référence aux [Fig.6a] à [Fig.11b].

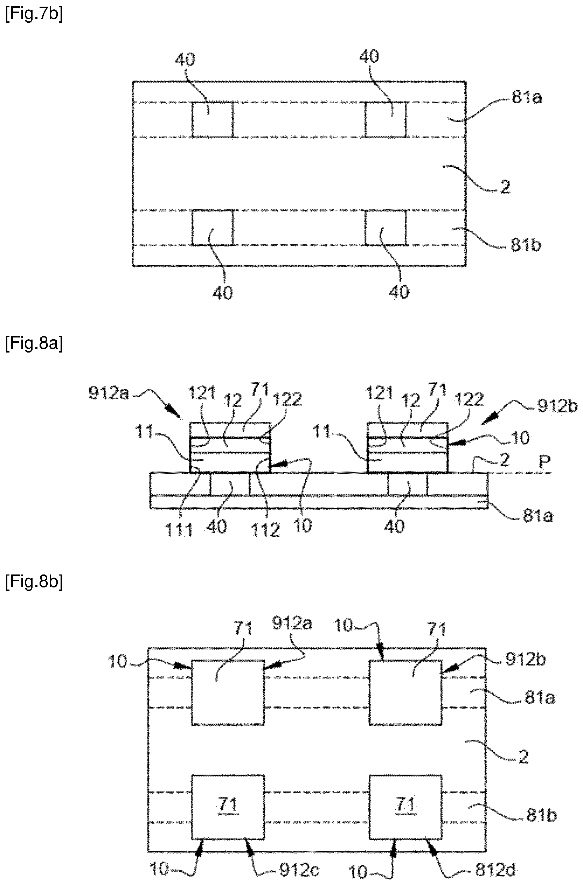

Les [Fig.8a] et [Fig.8b] représentent quatre premiers empilements intermédiaires 912a, 912b, 912c, 912d. Les quatre premiers empilements intermédiaires peuvent être réalisés simultanément, en vue de fabriquer une matrice 3 de mémoires résistives. La description ci-dessous vise un seul premier empilement intermédiaire 912a. Elle est toutefois transposable aux premiers empilements intermédiaires voisins 912b, 912c, 912d.

Le premier empilement intermédiaire 912a comprend, par exemple à partir de la surface d'une couche diélectrique 2, un empilement sélecteur 10 comprenant une couche sélectrice 11 et une électrode supérieure de sélecteur 12, s'étendant sur la couche sélectrice 11.

Pour obtenir ledit premier empilement intermédiaire 912a, le procédé de fabrication comprend dans un premier temps la formation de l'empilement sélecteur 10. Elle comprend notamment la formation d'une couche sélectrice 11, s'étendant parallèlement au plan P, par exemple sur la surface de la couche diélectrique 2. Il s'agit par exemple du dépôt d'une première couche, par exemple à base de Ge-Se-Sb-N et de la délimitation de ladite première couche de manière à former la couche sélectrice 11 (en pratique, l'ensemble de l'empilement sélecteur est délimité latéralement lors d'une même étape de gravure). La couche sélectrice 11 est ainsi délimitée par des troisième et quatrième flancs 111, 112.

La formation de l'empilement sélecteur 10 comprend également la formation d'une électrode supérieure de sélecteur 12, s'étendant sur la couche sélectrice 11. Il s'agit par exemple du dépôt d'une deuxième couche, par exemple en TiN, sur la couche sélectrice 11. Dans un deuxième temps, la deuxième couche est délimitée de manière à former l'électrode supérieure de sélecteur 12. L'électrode supérieure est ainsi délimitée latéralement une surface latérale comprenant au moins deux parties, dites premier et deuxième flancs 121, 122, ici.

De manière avantageuse, les première et deuxième couches peuvent être déposées successivement, l'une sur l'autre. Lesdites deux couches sont ensuite délimitées dans une même étape, de manière à former la couche sélectrice 11 et l'électrode supérieure de sélecteur 12.

Le premier empilement intermédiaire 912a peut également comprendre une couche isolante 71, s'étendant sur l'électrode supérieure de sélecteur 12. Auquel cas le procédé peut également comprendre une étape de dépôt d'une couche isolante sur les premières et deuxièmes couches de sorte que la délimitation de ces dernières permet également de délimiter la couche isolante 71.

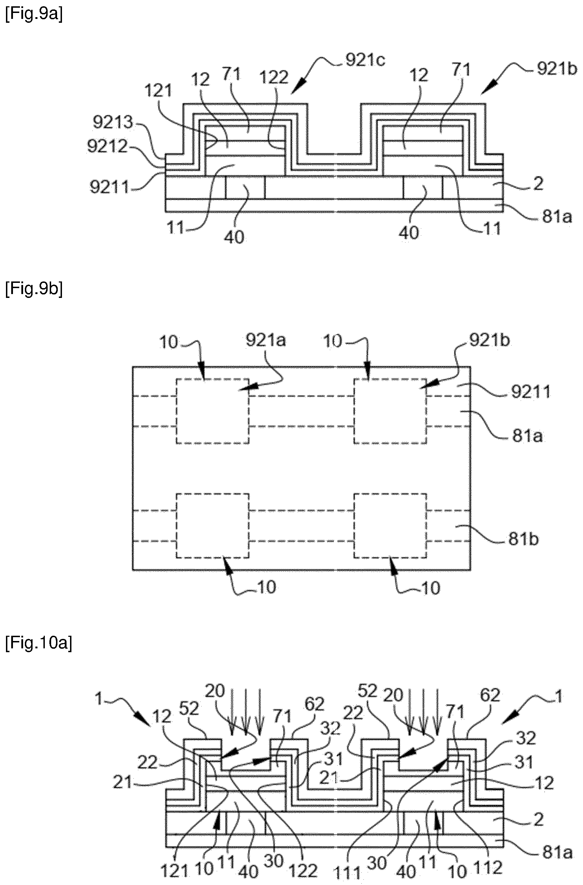

Les [Fig.9a] et [Fig.9b] représentent un deuxième empilement intermédiaire 921a comprenant une couche active globale 9211, recouvrant l'empilement sélecteur 10 et la surface de la couche diélectrique 2 non-recouverte par les empilements sélecteur 10. La couche active globale 9211 est destinée à former les première et deuxième couches actives 21, 31 des premier et deuxième empilement mémoire 20, 30.

Le deuxième empilement intermédiaire 921a peut également comprendre une première couche conductrice 9212 s'étend sur la couche active globale 9211, destinée à former les première et deuxième électrodes supérieures 22, 32 des premier et deuxième empilements mémoires 20, 30. Il peut également comprendre une deuxième couche conductrice 9213, destinée à former une partie au moins des premier et deuxième contacts électrique 50, 60. Ici, la deuxième couche conductrice 9213 est destinée, après gravure, à former des colonnes d'adressage de la matrice.

La formation des premier et deuxième empilements mémoire 20, 30 comprend dans un premier temps le dépôt de la couche active globale 9211 sur l'empilement sélecteur 10 et sur la couche diélectrique 2. Une première partie au moins de la couche active globale 9211 s'étend en vis-à-vis des premier et deuxième flancs 121, 122 de l'électrode supérieure de sélecteur 12. Le dépôt de la couche active globale 9211 est réalisé de manière conforme, par exemple de manière à présenter une épaisseur sensiblement constante en tout point. Par sensiblement constante, on entend à 20% près, voire 10% près, ou encore 5% près. Ce dépôt conforme est réalisé par exemple par « ALD » (pour « Atomic Layer Dépositions » en anglais).

Le procédé peut en outre comprendre le dépôt de la première couche conductrice 9212, par exemple par dépôt conforme, de sorte qu'elle s'étende sur la couche active 9211. Le procédé peut également comprendre le dépôt de la deuxième couche 9213, par exemple également par dépôt conforme, de sorte qu'elle s'étende sur la première couche conductrice 9212.

Les [Fig.10a] et [Fig.10b] représentent un ensemble 1, différent du deuxième empilement intermédiaire 921a de la [Fig.9a] en ce qu'il comprend des premier et deuxième empilements mémoire 20, 30, disposés de part et d'autre de l'empilement sélecteur 10 et des premier et deuxième contact électrique 52, 62.

Pour obtenir les premiers et deuxième empilements mémoire 20, 30, le procédé comprend la gravure de la couche active globale 9211 de manière à la séparer en une première couche active 21 et une deuxième couche active 31. La gravure est réalisée de sorte qu'une première partie au moins de la première couche active 21 s'étende en vis-à-vis du premier flanc 121 de l'électrode supérieure de sélecteur 12, préférentiellement parallèlement à celui-ci et de sorte qu'une deuxième partie au moins de la deuxième couche active 31 s'étende contre le deuxième flanc 122 de l'électrode supérieure de sélecteur 12, préférentiellement en vis-à-vis et parallèlement à celui-ci.

La gravure peut être stoppée avant d'atteindre l'électrode supérieure de sélecteur 12, afin de ne pas la dégrader. Quoiqu'il en soit, elle est stoppée avant d'atteindre la couche sélectrice 11, pour que l'électrode supérieure de sélecteur reste d'un seul tenant, sur l'ensemble de la couche sélectrice 11.

L'étape de gravure peut également graver dans le même temps la première couche conductrice 9212 en deux parties de sorte qu'elles forment respectivement les première et deuxième électrodes supérieures 22, 32, s'étendant par exemple respectivement sur les première et deuxième couches actives 21, 31.

Le procédé peut également comprendre le dépôt d'une couche isolante 71 sur l'électrode supérieure de sélecteur 12, avant le dépôt de la couche active globale 9211. La gravure 922 peut alors s'arrêter sur la couche isolante 71 ou s'arrêter dans ladite couche 71, créant par exemple une tranchée.

La formation des contacts électrique 52, 62 est par exemple réalisée au même moment que l'étape de gravure de la première couche conductrice 9212. Elle permet ainsi de séparer électriquement les contact électriques 52, 62 les uns des autres.

L'étape de gravure peut également permettre de séparer électriquement les deuxièmes empilements intermédiaires 921a, 921b voisins en séparant les couches 9211, 9212, 9213 déposées sur chaque empilement de sélecteur 10.

Le procédé peut comprendre, avant la formation de chaque empilement sélecteur 10, la formation d'au moins une ligne d'adressage 81a, 81b telle que représentée par les [Fig.6a] et [Fig.6b].

Le procédé peut également comprendre, avant la formation de chaque empilement sélecteur 10, la formation d'au moins un via inférieur 40 sur chaque ligne d'adressage 81a, 81b, tel que représenté par les [Fig.7a] et [Fig.7b].

Chaque ligne d'adressage 81a, 81b et chaque via inférieur 40 peut être réalisé par la mise en œuvre d'un procédé damascène. Il s'agit par exemple du dépôt d'un matériau diélectrique, de la gravure de cavités destinées à former les lignes d'adressage 81a, 81b ou les vias inférieurs 40 et le remplissage desdites cavités par un revêtement ou « liner » en anglais, par exemple en titane, et un matériau conducteur, par exemple du tungstène, suivi d'un polissage mécano-chimique (ou CMP).

Les lignes d'adressage 81a, 81b sont enterrées dans la couche diélectrique 2. Chaque via inférieur 40 traverse la couche diélectrique 2. Ladite couche diélectrique 2 et chaque via inférieur 40 sont mis à niveau par exemple au moyen d'une planarisation.

Les [Fig.11a] et [Fig.11b] représentent des ensembles 1 formant une matrice 3 de mémoires résistives. Chacun des premier et deuxième empilements mémoire 20, 30 des ensembles 1 sont reliés à des colonnes d'adressage 82a, 82b, 82c, 82d distinctes. Afin de connecter chaque empilement mémoire 20, 30, le procédé 9 peut comprendre la formation de colonne d'adressage 82a-d. Pour cela, les ensembles 1 sont enterrés sous une couche complémentaire de diélectrique 2a. La couche complémentaire de diélectrique 2a est mise à niveau de chaque contacts électriques 50, 60 par planarisation.

## Revendications

1. Ensemble (1a ; 1b ; 1c ; 1d) comprenant au moins deux mémoires résistives non volatiles disposées électriquement en parallèle entre elles et étant chacune électriquement connectées en série à une couche sélectrice commune, l'ensemble comprenant :
- un empilement sélecteur (10), comprenant :
- une couche sélectrice (11) qui s'étend parallèlement à un plan (P) donné ;
- une électrode supérieure de sélecteur (12) s'étendant sur la couche sélectrice (11), l'électrode supérieure étant délimitée latéralement par une surface latérale (121, 122) ;
- un premier empilement mémoire (20), qui s'étend de manière oblique ou perpendiculaire par rapport audit plan (P), comprenant une première couche active (21), une partie au moins de la première couche active (21) s'étendant contre une partie de la surface latérale (121) de l'électrode supérieure de sélecteur (12) ;
- un deuxième empilement mémoire (30), qui s'étend de manière oblique ou perpendiculaire par rapport audit plan (P), comprenant une deuxième couche active (31), une partie au moins de la deuxième couche active (31) s'étendant contre une autre partie de la surface latérale (122) de l'électrode supérieure de sélecteur (12) ;
- les premier et deuxième empilements mémoire (20, 30) étant disjoints, sans contact électrique direct entre eux ;
- un premier contact électrique (50), la première couche active (21) étant connectée électriquement entre, le premier contact électrique (50) d'une part, et, l'électrode supérieure de sélecteur (12) d'autre part ;
- un deuxième contact électrique (60), la deuxième couche active (31) étant connectée électriquement entre, le deuxième contact électrique (60) d'une part, et, l'électrode supérieure de sélecteur (12) d'autre part ;
- l'électrode supérieure de sélecteur (12) étant commune aux premier et deuxième empilements mémoire (20, 30) tandis que les premier et deuxième contacts (50, 60) sont isolés électriquement l'un de l'autre, sans contact électrique direct entre eux.

2. Ensemble (1a ; 1b ; 1c ; 1d) selon la revendication précédente, dans lequel la couche sélectrice (11) est délimitée latéralement par une surface latérale (111, 112) située, par exemple, dans le prolongement de la surface latérale (121, 122) de l'électrode supérieure de sélecteur (12).

3. Ensemble (1a ; 1b ; 1c ; 1d) selon l'une des revendications précédentes, dans lequel :
- la couche sélectrice (11) est située entre l'électrode supérieure de sélecteur (12) et un via inférieur (40) conducteur qui est situé sous la couche sélectrice (11) ;
- le via inférieur (40) ayant une section inférieure à la section de la couche sélectrice (11) et étant entouré par un matériau diélectrique qui s'étend sous la couche sélectrice (11).

4. Ensemble (1a ; 1b ; 1c ; 1d) selon la revendication précédente, dans lequel :
- le via inférieur (40) est délimité latéralement par une surface latérale (41, 42),
- le premier empilement mémoire (20) est délimité par une surface latérale externe (201), qui est la surface latérale la plus externe de cet empilement (20), la plus éloignée de la couche sélectrice (11), et dans lequel
- une partie de la surface latérale (41) du via inférieur (40), qui est située du côté du premier empilement mémoire (20), et la surface latérale externe (201) du premier empilement mémoire (20) sont toutes deux situées sous le premier contact électrique (50).

5. Ensemble (1a ; 1c ; 1d) selon l'une des revendications précédentes, dans lequel la ou les couches actives (21, 31), qui s'étendent en partie au moins contre ladite partie ou ladite autre partie de la surface latérale (121, 122) de l'électrode supérieure du sélecteur (12), sont en contact avec cette surface latérale (121, 122), directement, ou par l'intermédiaire d'une couche électriquement conductrice.

6. Ensemble (1b) selon la revendication 2 ou selon la revendication 3 ou 4 prise dans la dépendance de la revendication 2, comprenant en outre un espaceur (72) électriquement isolant, qui s'étend au moins contre la surface latérale (111, 112) de la couche sélectrice (11), une partie de la première couche active (21) étant séparée de la surface latérale (111) de la couche sélectrice (11) par cet espaceur (72).

7. Ensemble (1b) selon la revendication précédente, dans lequel :
- l'espaceur (72) s'étend en outre contre la surface latérale (121, 122) de l'électrode supérieure de sélecteur (12), entre une partie de la première couche active (21) et la surface latérale (121) de l'électrode supérieure de sélecteur (12) ;
- la première couche active (21) comprend une portion qui s'étend parallèlement audit plan (P) en venant recouvrir une partie de l'électrode supérieure de sélecteur (12), et qui est en contact avec une surface supérieure de l'électrode supérieure de sélecteur (12).

8. Ensemble (1d) selon l'une des revendications précédentes, comprenant au moins un empilement sélecteur additionnel (10'), situé au-dessus et au droit de l'empilement sélecteur (10), séparé de l'empilement sélecteur (10) par une couche isolante (71).

9. Ensemble (1d) selon la revendication précédente, dans lequel l'empilement sélecteur additionnel (10') comprend :
- sur ladite couche isolante (71), une électrode de sélecteur additionnelle (12'), délimitée latéralement par une surface latérale dite additionnelle (121', 122') ; et
- sur l'électrode de sélecteur additionnelle (12'), une couche sélectrice additionnelle (11'),
la première couche active (21) s'étend en outre contre une partie de la surface latérale additionnelle (121') de l'électrode supérieure de sélecteur additionnelle (12') ; la deuxième couche active (31) s'étend contre une autre partie de la surface latérale additionnelle (122') de l'électrode de sélecteur additionnelle (12'), l'ensemble (1d) comprend en outre un via supérieur (40'), situé au-dessus de la couche sélectrice additionnelle (11') et relié électriquement à la couche sélectrice additionnelle (11').

10. Ensemble (1d) selon la revendication précédente, dans lequel le via supérieur (40') a une section inférieure à la section de la couche sélectrice additionnelle (11') et est entouré d'un espaceur isolant additionnel (73) qui s'étend également sur une portion de la couche sélectrice additionnelle (11').

11. Matrice (3) de mémoires résistives non-volatiles comprenant une pluralité d'ensembles (1, 1') selon l'une des revendications précédentes, dans laquelle, pour chaque ensemble (1, 1') :
- l'empilement sélecteur (10) de l'ensemble considéré est relié électriquement à une ligne d'adressage (81a) de la matrice,
- les premier et deuxième contacts électriques (50, 60) de l'ensemble sont reliés électriquement, respectivement, à deux colonnes d'adressage (82a, 82b, 82c, 82d) distinctes de la matrice, ou forment respectivement deux colonnes d'adressage distinctes de la matrice.

12. Matrice (3) selon la revendication précédente, dans laquelle, pour au moins deux desdits ensembles (1c) voisins l'un de l'autre, la couche sélectrice de l'un des deux ensembles et la couche sélectrice de l'autre ensemble forment ensemble une même couche sélectrice globale (11) commune aux deux ensembles, d'un seul tenant, et dans laquelle un même via inférieur (40), commun aux deux ensembles, est relié électriquement à une face inférieure de la couche sélectrice globale (11).

13. Procédé de fabrication d'un ensemble (1a; 1b; 1c; 1d) comprenant au moins deux mémoires résistives non volatiles associées à un sélecteur, comprenant :
- la formation d'un empilement sélecteur (10) comprenant :
- le dépôt d'une couche sélectrice (11) s'étendant parallèlement à un plan (P) ; et
- le dépôt d'une électrode supérieure de sélecteur (12) s'étendant sur la couche sélectrice (11), l'électrode supérieure étant délimitée latéralement par une surface latérale (121, 122) ;
- la formation d'un premier empilement mémoire (20) et d'un deuxième empilement mémoire (30) comprenant :
- le dépôt conforme d'une couche active globale sur l'empilement sélecteur, une première partie au moins de la couche active globale s'étendant contre une partie de la surface latérale (121) de l'électrode supérieure de sélecteur (12) et une deuxième partie au moins de la couche active globale s'étendant contre une autre partie de la surface latérale (122) de l'électrode supérieure de sélecteur (12) ;
- la séparation de la couche active globale en au moins une première couche active (21) et une deuxième couche active (31) disjointes,
- une partie au moins de la première couche active (21) s'étendant de manière oblique, ou même perpendiculaire par rapport audit plan (P), et contre la partie de la surface latérale (121) de l'électrode supérieure de sélecteur (12) ; et
- une deuxième partie au moins de la deuxième couche active (31) s'étendant de manière oblique, ou même perpendiculaire par rapport audit plan (P), et contre l'autre partie de la surface latérale (122) de l'électrode supérieure de sélecteur (12) ;
- l'électrode supérieure de sélecteur (12) étant commune aux premier et deuxième empilements mémoire (20, 30)
- la formation d'un premier contact électrique (50) et d'un deuxième contact électrique (60), isolés électriquement l'un de l'autre, la première couche active (21) étant connectée électriquement entre, le premier contact électrique (50) d'une part, et, l'électrode supérieure de sélecteur (12) d'autre part, la deuxième couche active (22) étant connectée électriquement entre, le deuxième contact électrique (60) d'une part, et, l'électrode supérieure de sélecteur (12) d'autre part.

## Patentansprüche

1. Array (1a; 1b; 1c; 1d) mit mindestens zwei nichtflüchtigen resistiven Speichern, die elektrisch parallel zueinander angeordnet sind und elektrisch jeweils in Reihe mit einer gemeinsamen Selektorschicht verbunden sind, wobei das Array umfasst:
- einen Selektorstapel (10), umfassend:
o eine Selektorschicht (11), die sich parallel zu einer gegebenen Ebene (P) erstreckt;
o eine obere Selektorelektrode (12), die sich über die Selektorschicht (11) erstreckt, wobei die obere Elektrode seitlich durch eine Seitenfläche (121, 122) begrenzt ist;
- einen ersten Speicherstapel (20), der sich schräg oder senkrecht zu der Ebene (P) erstreckt und eine erste aktive Schicht (21) umfasst, wobei sich mindestens ein Teil der ersten aktiven Schicht (21) an einem Teil der Seitenfläche (121) der oberen Selektorelektrode (12) erstreckt;
- einen zweiten Speicherstapel (30), der sich schräg oder senkrecht zu der Ebene (P) erstreckt und eine zweite aktive Schicht (31) umfasst, wobei sich mindestens ein Teil der zweiten aktiven Schicht (31) an einem anderen Teil der Seitenfläche (122) der oberen Selektorelektrode (12) erstreckt;
- wobei der erste und der zweite Speicherstapel (20, 30) voneinander getrennt sind und keinen direkten elektrischen Kontakt miteinander haben;
- einen ersten elektrischen Kontakt (50), wobei die erste aktive Schicht (21) zwischen dem ersten elektrischen Kontakt (50) einerseits und der oberen Selektorelektrode (12) andererseits elektrisch verbunden ist;
- einen zweiten elektrischen Kontakt (60), wobei die zweite aktive Schicht (31) zwischen dem zweiten elektrischen Kontakt (60) einerseits und der oberen Selektorelektrode (12) andererseits elektrisch verbunden ist;
- wobei die obere Selektorelektrode (12) dem ersten und dem zweiten Speicherstapel (20, 30) gemeinsam ist, während der erste und der zweite Kontakt (50, 60) elektrisch voneinander isoliert sind, ohne dass zwischen ihnen ein direkter elektrischer Kontakt besteht.

2. Array (1a; 1b; 1c; 1d) nach dem vorhergehenden Anspruch, in dem die Selektorschicht (11) seitlich durch eine Seitenfläche (111, 112) begrenzt ist, die sich beispielsweise in der Verlängerung der Seitenfläche (121, 122) der oberen Selektorelektrode (12) befindet.

3. Array (1a; 1b; 1c; 1d) nach einem der vorhergehenden Ansprüche, in dem:
- die Selektorschicht (11) zwischen der oberen Selektorelektrode (12) und einer unteren leitenden Durchkontaktierung (40) angeordnet ist, die sich unterhalb der Selektorschicht (11) befindet;
- die untere Durchkontaktierung (40) einen Querschnitt aufweist, der kleiner ist als der Querschnitt der Selektorschicht (11), und von einem dielektrischen Material umgeben ist, das sich unter der Selektorschicht (11) erstreckt.

4. Array (1a; 1b; 1c; 1d) nach dem vorhergehenden Anspruch, in dem:
- die untere Durchkontaktierung (40) seitlich durch eine Seitenfläche (41, 42) begrenzt ist,
- der erste Speicherstapel (20) durch eine äußere Seitenfläche (201) begrenzt ist, die die äußerste Seitenfläche dieses Stapels (20) ist, die am weitesten von der Selektorschicht (11) entfernt ist, und in dem
- ein Teil der Seitenfläche (41) der unteren Durchkontaktierung (40), die sich auf der Seite des ersten Speicherstapels (20) befindet, und die äußere Seitenfläche (201) des ersten Speicherstapels (20) sich beide unter dem ersten elektrischen Kontakt (50) befinden.

5. Array (1a; 1c; 1d) gemäß einem der vorhergehenden Ansprüche, in dem die aktive(n) Schicht(en) (21, 31), die sich zumindest teilweise gegen den einen oder den anderen Teil der Seitenfläche (121, 122) der oberen Selektorelektrode (12) erstrecken, mit dieser Seitenfläche (121, 122) direkt oder über eine elektrisch leitende Schicht in Kontakt stehen.

6. Array (1b) nach Anspruch 2 oder nach Anspruch 3 oder 4 in Abhängigkeit von Anspruch 2, das außerdem einen elektrisch isolierenden Abstandshalter (72) umfasst, der sich zumindest gegen die Seitenfläche (111, 112) der Selektorschicht (11) erstreckt, wobei ein Teil der ersten aktiven Schicht (21) durch diesen Abstandshalter (72) von der Seitenfläche (111) der Selektorschicht (11) getrennt ist.

7. Array (1b) nach dem vorhergehenden Anspruch, in dem:
- sich der Abstandshalter (72) außerdem an der Seitenfläche (121, 122) der oberen Selektorelektrode (12) zwischen einem Teil der ersten aktiven Schicht (21) und der Seitenfläche (121) der oberen Selektorelektrode (12) erstreckt;
- die erste aktive Schicht (21) einen Abschnitt umfasst, der sich parallel zu der Ebene (P) erstreckt, einen Teil der oberen Selektorelektrode (12) bedeckt und mit einer oberen Fläche der oberen Selektorelektrode (12) in Kontakt steht.

8. Array (1d) nach einem der vorhergehenden Ansprüche, das mindestens einen zusätzlichen Selektorstapel (10') umfasst, der sich oberhalb und senkrecht zum Selektorstapel (10) befindet und durch eine Isolierschicht (71) vom Selektorstapel (10) getrennt ist.

9. Array (1d) nach dem vorhergehenden Anspruch, in dem der zusätzliche Selektorstapel (10') umfasst:
- auf der Isolierschicht (71) eine zusätzliche Selektorelektrode (12'), die seitlich durch eine sogenannte zusätzliche Seitenfläche (121', 122') begrenzt ist; und
- auf der zusätzlichen Selektorelektrode (12') eine zusätzliche Selektorschicht (11'),
wobei sich die erste aktive Schicht (21) außerdem gegen einen Teil der zusätzlichen Seitenfläche (121') der oberen zusätzlichen Selektorelektrode (12') erstreckt; wobei sich die zweite aktive Schicht (31) gegen einen anderen Teil der zusätzlichen Seitenfläche (122') der zusätzlichen Selektorelektrode (12') erstreckt, das Array (1d) ferner eine obere Durchkontaktierung (40') umfasst, die sich über der zusätzlichen Selektorschicht (11') befindet und mit der zusätzlichen Selektorschicht (11') elektrisch verbunden ist.

10. Array (1d) nach dem vorhergehenden Anspruch, in dem die obere Durchkontaktierung (40') einen Querschnitt aufweist, der kleiner ist als der Querschnitt der zusätzlichen Selektorschicht (11'), und von einem zusätzlichen isolierenden Abstandshalter (73) umgeben ist, der sich ebenfalls über einen Teil der zusätzlichen Selektorschicht (11') erstreckt.

11. Matrix (3) aus nichtflüchtigen resistiven Speichern, die eine Vielzahl von Arrays (1, 1') gemäß einem der vorhergehenden Ansprüche umfasst, in der für jedes Array (1, 1') gilt:
- der Selektorstapel (10) des betreffenden Arrays ist mit einer Adressierungszeile (81a) der Matrix elektrisch verbunden,
- der erste und der zweite elektrische Kontakt (50, 60) des Arrays sind jeweils mit zwei unterschiedlichen Adressierungsspalten (82a, 82b, 82c, 82d) der Matrix verbunden oder bilden jeweils zwei unterschiedliche Adressierungsspalten der Matrix.

12. Matrix (3) nach dem vorhergehenden Anspruch, in der für mindestens zwei der einander benachbarten Arrays (1c) die Selektorschicht eines der beiden Arrays und die Selektorschicht des anderen Arrays zusammen eine einzige, für beide Arrays gemeinsame, einstückige Gesamtselektorschicht (11) bilden, und in der eine einzige, für beide Arrays gemeinsame untere Durchkontaktierung (40) mit einer Unterseite der Gesamtselektorschicht (11) elektrisch verbunden ist.

13. Verfahren zur Herstellung eines Arrays (1a; 1b; 1c; 1d) mit mindestens zwei nichtflüchtigen resistiven Speichern, die einem Selektor zugeordnet sind, umfassend:
- das Bilden eines Selektorstapels (10), umfassend:
o das Aufbringen einer Selektorschicht (11), die sich parallel zu einer Ebene (P) erstreckt; und
o das Aufbringen einer oberen Selektorelektrode (12), die sich über der Selektorschicht (11) erstreckt, wobei die obere Elektrode seitlich durch eine Seitenfläche (121, 122) begrenzt ist;
- das Bilden eines ersten Speicherstapels (20) und eines zweiten Speicherstapels (30), umfassend:
o das konforme Aufbringen einer globalen aktiven Schicht auf den Selektorstapel, wobei sich mindestens ein erster Teil der gesamten aktiven Schicht gegen einen Teil der Seitenfläche (121) der oberen Selektorelektrode (12) erstreckt und sich mindestens ein zweiter Teil der gesamten aktiven Schicht gegen einen anderen Teil der Seitenfläche (122) der oberen Selektorelektrode (12) erstreckt;
o die Trennung der gesamten aktiven Schicht in mindestens eine erste aktive Schicht (21) und eine zweite aktive Schicht (31), die voneinander getrennt sind,
▪ wobei sich mindestens ein Teil der ersten aktiven Schicht (21) schräg oder sogar senkrecht zur Ebene (P) und an dem Teil der Seitenfläche (121) der oberen Selektorelektrode (12) erstreckt; und
▪ wobei sich mindestens ein zweiter Teil der zweiten aktiven Schicht (31) schräg oder sogar senkrecht zur Ebene (P) und an dem anderen Teil der Seitenfläche (122) der oberen Selektorelektrode (12) erstreckt;
o wobei die obere Selektorelektrode (12) dem ersten und dem zweiten Speicherstapel (20, 30) gemeinsam ist
- das Bilden eines ersten elektrischen Kontakts (50) und eines zweiten elektrischen Kontakts (60), die elektrisch voneinander isoliert sind, wobei die erste aktive Schicht (21) zwischen dem ersten elektrischen Kontakt (50) einerseits und der oberen Selektorelektrode (12) andererseits elektrisch verbunden ist, wobei die zweite aktive Schicht (22) zwischen dem zweiten elektrischen Kontakt (60) einerseits und der oberen Selektorelektrode (12) andererseits elektrisch verbunden ist.

## Claims

1. An assembly (1a; 1b; 1c; 1d) comprising at least two non-volatile resistive memories electrically disposed in parallel with each other and each being electrically connected in series to a common selective layer, the assembly comprising:
- a selective stack (10), comprising:
- a selective layer (11) which extends in parallel to a given plane (P);
- an upper selector electrode (12) extending on the selective layer (11), the upper electrode being laterally delimited by a side surface (121, 122);
- a first memory stack (20), which extends obliquely or perpendicularly to said plane (P), comprising a first active layer (21), at least a part of the first active layer (21) extending against a part of the side surface (121) of the upper selector electrode (12);
- a second memory stack (30), which extends obliquely or perpendicularly to said plane (P), comprising a second active layer (31), at least a part of the second active layer (31) extending against another part of the side surface (122) of the upper selector electrode (12);
- the first and second memory stacks (20, 30) being disjoint, with no direct electrical contact therebetween;
- a first electrical contact (50), the first active layer (21) being electrically connected between, on the one hand, the first electrical contact (50) and, on the other hand, the upper selector electrode (12);
- a second electrical contact (60), the second active layer (31) being electrically connected between, on the one hand, the second electrical contact (60) and, on the other hand, the upper selector electrode (12);
- the upper selector electrode (12) being common to the first and second memory stacks (20, 30), while the first and second contacts (50, 60) are electrically insulated from each other, with no direct electrical contact therebetween.

2. The assembly (1a; 1b; 1c; 1d) according to the preceding claim, wherein the selective layer (11) is laterally delimited by a side surface (111, 112) located, for example, as an extension of the side surface (121, 122) of the upper selector electrode (12).

3. The assembly (1a; 1b; 1c; 1d) according to one of the preceding claims, wherein:
- the selective layer (11) is located between the upper selector electrode (12) and a conductive lower via (40) which is located beneath the selective layer (11);
- the lower via (40) having a cross-sectional area smaller than the cross-sectional area of the selective layer (11) and being surrounded by a dielectric material which extends beneath the selective layer (11).

4. The assembly (1a; 1b; 1c; 1d) according to the preceding claim, wherein:
- the lower via (40) is laterally delimited by a side surface (41, 42),
- the first memory stack (20) is delimited by an outer side surface (201), which is the outermost side surface of this stack (20), furthest from the selective layer (11), and wherein
- a part of the side surface (41) of the lower via (40), which is located on the side of the first memory stack (20), and the outer side surface (201) of the first memory stack (20) are both located beneath the first electrical contact (50).

5. The assembly (1a; 1c; 1d) according to one of the preceding claims, wherein the active layer or layers (21, 31), which at least partly extend against said part or said other part of the side surface (121, 122) of the upper selector electrode (12), are in contact with this side surface (121, 122), directly, or through an electrically conductive layer.

6. The assembly (1b) according to claim 2 or according to claim 3 or 4 taken in dependence on claim 2, further comprising an electrically insulating spacer (72), which extends at least against the side surface (111, 112) of the selective layer (11), a part of the first active layer (21) being separated from the side surface (111) of the selective layer (11) by this spacer (72).

7. The assembly (1b) according to the preceding claim, wherein:
- the spacer (72) further extends against the side surface (121, 122) of the upper selector electrode (12), between a part of the first active layer (21) and the side surface (121) of the upper selector electrode (12);
- the first active layer (21) comprises a portion which extends in parallel to said plane (P) covering a part of the upper selector electrode (12), and which is in contact with an upper surface of the upper selector electrode (12).

8. The assembly (1d) according to one of the preceding claims, comprising at least one additional selective stack (10'), located above and in line with the selective stack (10), separated from the selective stack (10) by an insulating layer (71).

9. The assembly (1d) according to the preceding claim, wherein the additional selective stack (10') comprises:
- on said insulating layer (71), an additional selector electrode (12'), laterally delimited by a so-called additional side surface (121', 122'); and
- on the additional selector electrode (12'), an additional selective layer (11'),
the first active layer (21) further extends against a part of the additional side surface (121') of the additional upper selector electrode (12'); the second active layer (31) extends against another part of the additional side surface (122') of the additional selector electrode (12'), the assembly (1d) further comprises an upper via (40'), located above the additional selective layer (11') and electrically connected to the additional selective layer (11').

10. The assembly (1d) according to the preceding claim, wherein the upper via (40') has a cross-sectional area smaller than the cross-sectional area of the additional selective layer (11') and is surrounded by an additional insulating spacer (73) which also extends on a portion of the additional selective layer (11').

11. An array (3) of non-volatile resistive memories comprising a plurality of assemblies (1, 1') according to one of the preceding claims, wherein, for each assembly (1, 1'):
- the selective stack (10) of the assembly under consideration is electrically connected to an addressing row (81a) of the array,
- the first and second electrical contacts (50, 60) of the assembly are electrically connected to two distinct addressing columns (82a, 82b, 82c, 82d) of the array respectively, or form two distinct addressing columns of the array respectively.

12. The array (3) according to the preceding claim, wherein, for at least two of said assemblies (1c) neighbouring to one another, the selective layer of one of both assemblies and the selective layer of the other assembly together form a single overall selective layer (11) common to both assemblies, in a single piece, and wherein a single lower via (40), common to both assemblies, is electrically connected to a lower face of the overall selective layer (11).

13. A method for manufacturing an assembly (1a; 1b; 1c; 1d) comprising at least two non-volatile resistive memories associated with a selector, comprising:
- forming a selective stack (10) comprising:
- depositing a selective layer (11) extending in parallel to a plane (P); and
- depositing an upper selector electrode (12) extending on the selective layer (11), the upper electrode being laterally delimited by a side surface (121, 122);
- forming a first memory stack (20) and a second memory stack (30) comprising:
- conformally depositing an overall active layer on the selective stack, at least a first part of the overall active layer extending against a part of the side surface (121) of the upper selector electrode (12) and at least a second part of the overall active layer extending against another part of the side surface (122) of the upper selector electrode (12);
- separating the overall active layer into at least a first active layer (21) and a second active layer (31) which are disjoint,
- at least a part of the first active layer (21) extending obliquely, or even perpendicularly to said plane (P), and against a part of the side surface (121) of the upper selector electrode (12); and
- at least a second part of the second active layer (31) extending obliquely or even perpendicularly to said plane (P) and against the other part of the side surface (122) of the upper selector electrode (12);
- the upper selector electrode (12) being common to the first and second memory stacks (20, 30)
- forming a first electrical contact (50) and a second electrical contact (60), electrically insulated from each other, the first active layer (21) being electrically connected between, on the one hand, the first electrical contact (50) and, on the other hand, the upper selector electrode (12), the second active layer (22) being electrically connected between, on the one hand, the second electrical contact (60) and, on the other hand, the upper selector electrode (12).
